(19) Europäisches Patentamt
European Patent Office
Office européen des brevets

(11) EP 4 057 782 A1

(12) **EUROPEAN PATENT APPLICATION**

(43) Date of publication:
**14.09.2022 Bulletin 2022/37**

(21) Application number: **21162439.0**

(22) Date of filing: **12.03.2021**

(51) International Patent Classification (IPC):
***H05K 3/38*** *(2006.01)*

(52) Cooperative Patent Classification (CPC):
**H05K 3/389; H05K 3/385;** H05K 2203/0315; H05K 2203/0392; H05K 2203/0766; H05K 2203/0789; H05K 2203/0793; H05K 2203/0796; H05K 2203/124

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Atotech Deutschland GmbH & Co. KG
10553 Berlin (DE)**

(72) Inventors:
- **Belova-Magri, Valentina
10553 Berlin (DE)**
- **Ackermann, Stefanie
10553 Berlin (DE)**
- **Michalik, Fabian
10553 Berlin (DE)**
- **Haarmann, Philipp
10553 Berlin (DE)**
- **Thoms, Martin
10553 Berlin (DE)**
- **Lützow, Norbert
10553 Berlin (DE)**
- **Knaup, Jan
10553 Berlin (DE)**
- **Königsmann, Tatjana
10553 Berlin (DE)**

(74) Representative: **Atotech Deutschland GmbH & Co. KG
Intellectual Property
Erasmusstraße 20
10553 Berlin (DE)**

(54) **METHOD FOR INCREASING ADHESION STRENGTH BETWEEN COPPER AND AN ORGANIC MATERIAL AND REDUCING HALO AND WEDGE VOID FORMATION BY MODIFYING THE COPPER SURFACE AND/OR BY USING HETEROAROMATIC SILANE COMPOUNDS**

(57) The present invention relates to a method for increasing adhesion strength between a surface of a copper, a copper alloy or a copper oxide and a surface of an organic material.

Figure 1

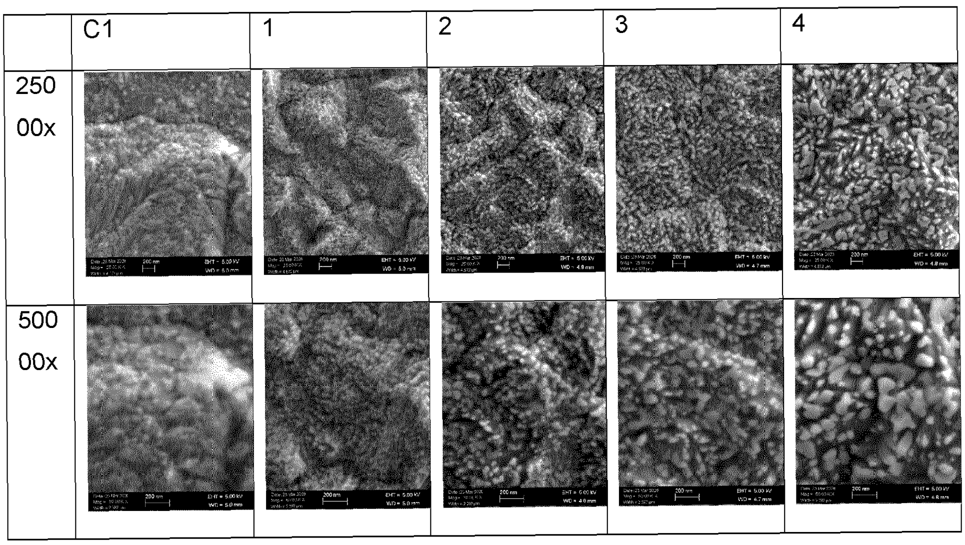


EP 4 057 782 A1

## Description

### Field of the Invention

The present invention relates to a method for increasing adhesion strength between a surface of a copper, a copper alloy or a copper oxide and a surface of an organic material and reducing halo and wedge void formation.

### Background of the Invention

In the Semi Additive Process build up sequence used in production of Integrated Circuit (IC) Substrates one of the key tasks is to form a strong adhesive bond between adjacent layers where there is intrinsically no natural adhesive force. The fundamental challenge here is to form a strong bond between the copper traces and the dielectric materials used in either build up layers or final solder masks coatings, with no negative impact upon final product performance.

In former times the most commonly used adhesion promotor systems provided a high degree of roughening of the copper surface; this roughened surface can then act as a key to form mechanical bonds with the dielectric materials (e.g. organic resin systems) and the copper traces. However, this type of system which is based upon a maximum increase in copper surface area for a minimum amount of copper removed is now no longer acceptable. As conductor features become smaller and smaller it is ever more challenging to form reliable structures to the desired line and space tolerance, therefore it is totally undesirable to introduce an adhesion promotor step based upon a high degree of surface roughening.

In addition, a second challenge is now faced with the advent 5G systems where there is strong relationship between signal integrity and surface roughening. As the frequency and rate of data transfer of the electrical signal increase, the path of the electrical signal moves into the outer most skin of the copper trace. Obviously if this "skin" has been highly roughened to increase adhesion with buildup layers there is a much higher risk that some of the signal will be lost or slowed down. With any such loss then the ability to perform at the required high frequency range is also impaired.

To overcome these challenges, it is desired to develop a method for a treatment of the copper surface and/or the dielectric materials in which the adhesion between both materials is increased without etching and/or roughening of the copper surface.

Heteroaromatic silane compounds are frequently utilized in the manufacturing of electronic components, in particular in surface treatment solutions, e.g. for the treatment of copper surfaces and surfaces of organic materials as a preparation for further processing steps.

US 2016/0368935 A1 relates to an azole silane compound, and a surface treatment solution using the azole silane compound, a surface treatment method and use thereof.

JP 2018016865 A discloses a triazole surface treatment agent containing a silane compound.

JP 2014240522 A refers to a copper surface treatment liquid, a surface treatment method, and its utilization.

JP H06279461 A refers to a surface-treating agent for copper foils used for copper-clad laminate boards for printed circuits.

The article "Corrosion protection of copper with 3-glycidoxypropyltrimethoxysilane-based sol-gel coating through 3-amino-5-mercapto-1,2,4-triazole doping", Journal of Research on Chemical Intermediates, Volume 42, Issue 2, pages 1315 to 1328, 2015, discloses a study about corrosion protection of copper in a neutral medium by the formation of a sol-gel coating over the copper surface. It discloses that a 3-amino-5-mercapto-1,2,4-triazole-doped 3-glydidoxypropyltrimethoxysilane-based sol-gel coating on copper forms a thiolate bond to copper.

WO2019/243180 discloses azole silane compounds, the synthesis thereof as well as respective solution and the use in surface treatment.

WO2020/178146 discloses the use of azole silane compounds in a method for increasing adhesion strength between a surface of a metal, a metal alloy or a metal oxide and a surface of an organic material.

WO 2019/058773 A discloses tetrazole silanes, a method for synthesizing and use of the tetrazole silanes in surface treatment.

JP2016169300A (JP6436819B2) discloses 2,4-Diamine-substituted triazines which do not comprise silicon.

2,4,6-Triamine-substituted triazines are disclosed in Chem. Eur.J. 2009, 15, 6279-6288 and JP 2017002402 A (JP6370836B2). The use thereof in epoxy resins is disclosed in JP6392273.

In "The role of oxide structure on copper wire to the rubber adhesion", Applied Surface Science Vol. 161, p. 355-364, 2000, the adhesion of millimeter-sized copper wires to rubber was investigated. The bonding is dependent on the reaction of copper oxide with sulfur.

"Reliability prediction in electronic packages using molecular simulation", Electronic Components and Technology Conference, p. 1314-1317, 2005, discloses the molecular dynamics (MD) simulation of interactions between epoxy molding compound (EMC) and copper oxide.

Adhesion strength is related to the physical and chemical strength by which the adhesion layer is bound to the

surface of a copper, a copper alloy or a copper oxide.

Another aspect related to adhesion strength is the avoidance of wedge void formation. This means that after the typical process steps of lamination, curing and, lasering, the wedge-like structures form after desmear and reducing steps at the interface between substrate and laminate. These so-called wedge voids are unwanted since they facilitate the peel off of the laminate. The wedge voids are often already seen as halo ring around the drilled hole (blind micro-via) indicating the chemical propagation to the substrate.

## Objective of the present Invention

It was therefore the objective of the present invention, based on the above-mentioned problems, to provide a method for a treatment of the copper surface and/or the dielectric materials in which the adhesion between both materials is increased, preferably without etching and/or roughening of the copper surface.

It was an additional task to provide a method which does not exhibit the disadvantages regarding adhesion strength and wedge void formation as described above.

## Description of the Invention

Above mentioned objectives are solved by a method for increasing adhesion strength and/or improved wedge void behavior between a surface of copper, a copper alloy or a copper oxide and a surface of an organic material comprising

(i) providing a substrate, comprising the copper, copper alloy or copper oxide on at least one side of the substrate, followed by at least one of the steps of

(i-c) treating the substrate yielding a substrate comprising copper oxide on at least one side of the substrate, wherein the copper oxide comprises copper (I) and copper (II) in a ratio of 90:10 or higher (mol/mol), preferably in a ratio of 95:5 or higher (mol/mol), even more preferably in a ratio of 98:2 or higher (mol/mol), most preferably the copper oxide essentially consists of copper (I) oxide;

and/or

(ii) contacting at least one section of the substrate with

(a) at least one silane compound of formula (I);

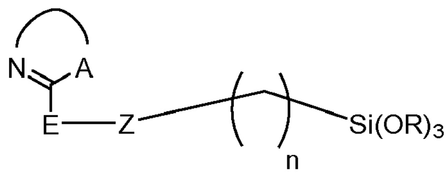

(I)

wherein

the ring structure

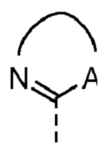

is selected from the group consisting of

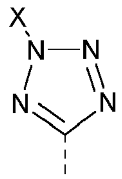, 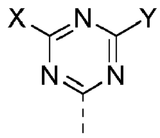, 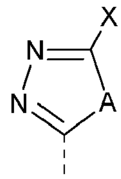

and mixtures thereof;

X and Y are independently selected from the group consisting of $NH_2$, $NH(NH_2)$, $NH(CH_2)_oNH_2$, SH, $SCH_3$, and $OCH_3$;

E is selected from the group consisting of-S- , -NH- and $-NH-(CH_2)_m-NH-$;

A is selected from the group consisting of NH, $N(NH_2)$ and S;

Z is selected from the group consisting of

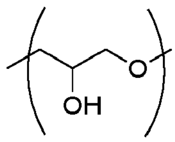 and 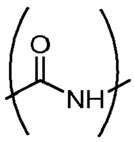,

m is an integer in the range from 2 to 12,

n is an integer in the range from 1 to 12,

o is an integer in the range from 2 to 12,

R independently denotes $(CH_2-CH_2-O)_p-T$, wherein independently

p is 0, 1, 2, 3, or 4, and

T denotes H or C1 to C5 alkyl; or

(b) at least one amino acid; or

a mixture of (a) and (b),

wherein, if both steps (i-c) and (ii) are performed, step (1-c) is performed prior to step (ii);

(iii) applying the organic material,

with the proviso that, if the ring structure

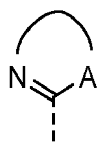

in the silane compound of formula (I) is

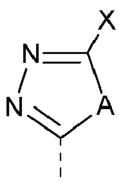,

both steps (i-c) and (ii) are performed.

Own experiments have surprisingly shown that the adhesion strength between the copper, copper alloy or copper oxide and an organic material can be increased without etching or a noticeable removal of copper, copper alloy or copper oxide. It can be shown that whereas the relative surface area (RSAI) of the copper, copper alloy or copper oxide is increased, the average surface roughness (Ra) is not increased. In other words, after step (i) the average surface roughness of the copper, copper alloy or copper oxide is substantially the same compared to the start of step (i). This differentiates the method of the present invention over a number of known methods, in particular etching methods, which have the goal to increase the total surface area by roughening. Therefore, the method of the present invention is preferably a non-etching method.

Preferred is a method of the present invention, wherein in step (i) the copper, copper alloy or copper oxide comprises a copper, copper alloy or copper oxide circuitry, preferably is a copper, copper alloy or copper oxide circuitry. In such a case the copper, copper alloy or copper oxide circuitry is structured. It preferably means that the organic material simultaneously exposes on the same side non-conductive (preferably organic) areas as well as conductive copper, copper alloy or copper oxide areas. This is most preferred in the context of the method of the present invention.

Preferred is a method of the present invention, wherein in step (i) the copper, copper alloy or copper oxide forms at least one layer on the substrate. As described above this layer or these layers can be structured and can form or be a circuitry.

Preferred is a method of the present invention, wherein in step (i) (and/or preferably after step (ii)) the copper, copper alloy or copper oxide circuitry comprises lines with a line width of 100 μm or less, preferably 75 μm or less, more preferably 55 μm or less. In some cases, a method of the present invention is preferred, wherein in step (i) (and/or preferably after step (ii)) the copper, copper alloy or copper oxide circuitry comprises lines with a line width of 30 μm or less, preferably of 20 μm or less, most preferably of 10 μm or less.

<u>Method comprising step (i-c) - Formation of copper (I) oxide</u>

It has surprisingly been found that copper oxide surfaces with a high copper (I) content compared to copper (II) exhibit both a good adhesion behavior while exhibiting at the same time a flat (or smooth) surface. This is surprising because the typical paradigm is "the rougher the surface is the better is the adhesion". For the reasons describes above rough surfaces are not wanted for highly demanding electronic applications.

Hence, it was found that the underlying problems could be solved by providing a method for increasing adhesion strength and/or improved wedge void behavior between a surface of copper, a copper alloy or a copper oxide and a surface of an organic material comprising

(i) providing a substrate, comprising the copper, copper alloy or copper oxide on at least one side of the substrate, followed by the step of

(i-c) treating the substrate yielding a substrate comprising copper oxide on at least one side of the substrate, wherein the copper oxide comprises copper (I) and copper (II) in a ratio of 90:10 or higher (mol/mol), preferably in a ratio of 95:5 or higher (mol/mol), even more preferably in a ratio of 98:2 or higher (mol/mol), most preferably the copper oxide essentially consists of copper (I) oxide;

(iii) applying the organic material.

It has been found that the inventive copper (I) oxide surfaces can be obtained when step (i-c) is performed by means of contacting the at least one section of said copper, copper alloy or copper oxide with an aqueous alkaline solution comprising one or more than one complexing agent.

Hence, preferably step (i-c) comprises contacting at least one section of said copper, copper alloy or copper oxide with an aqueous alkaline solution comprising one or more than one complexing agent.

The alkaline solution of the method of the present invention is an aqueous alkaline solution. In the context of the present invention, "aqueous" denotes that the solution comprises water. Preferred is a solution utilized in the method of the present invention, wherein more than 50 vol% of the total volume of the oxidizing solution is water, preferably 70 vol% or more, more preferably 80 vol% or more, even more preferably 90 vol% or more, most preferably 95 vol% or more. Most preferably, the solution comprises water with the proviso that water is the only solvent.

The term "alkaline" means that the solution has a pH of more than 7, preferably of 9 or more, even more preferably of 11 or more, most preferably of 12.5 or more. Preferred is a solution in step (i-c) of the method of the present invention, wherein the pH is in a range from 8 to 14, more preferably in a range from 9 to 14, even more preferably in a range from 10 to 14, yet even more preferably in a range from 11 to 14, most preferably in a range from 12 to 14.

In order to obtain an alkaline pH, the solution comprises hydroxide ions, preferably in a concentration in a range from 0.1 mol/L to 2.0 mol/L, based on the total volume of the solution, preferably in a range from 0.2 mol/L to 1.8 mol/L, even more preferably in a range from 0.3 mol/L to 1.6 mol/L, yet even more preferably in a range from 0.4 mol/L to 1.5 mol/L, most preferably in a range from 0.5 mol/L to 1.2 mol/L. Such concentrations result in a preferably strong alkaline oxidizing solution, e.g. pH 13 or higher.

Preferred is a solution comprising one or more than one source of hydroxide ions, preferably one source of hydroxide ions.

A preferred source of hydroxide ions is an inorganic hydroxide, an organic hydroxide, or mixtures thereof. An inorganic hydroxide is preferably selected from the group consisting of ammonium hydroxide and alkaline hydroxides, is preferably selected from the group consisting of ammonium hydroxide, sodium hydroxide, and potassium hydroxide.

A preferred organic hydroxide is an alkyl ammonium hydroxide, preferably tetra alkyl ammonium hydroxide, more preferably tetra methyl ammonium hydroxide.

The aqueous alkaline solution comprises one or more than one copper complexing agent. The complexing agent typically serves to complex copper ions that are solubilized when applying the alkaline solution on the copper surface, which avoids formation of insoluble copper hydroxides. Typically, a complexing agent for copper ions prevents or at least significantly reduces such hydroxide formation. Thus, preferred is a method of the present invention, wherein the alkaline solution additionally comprises one or more than one complexing agent for complexing copper ions, preferably one or more than one complexing agent comprising at least one carboxylic group and at least one hydroxyl group.

More preferred is a method of the present invention, wherein in the alkaline solution the one or more than one complexing agent comprises a sugar, preferably a monomeric sugar.

Even more preferred is a method of the present invention, wherein the one or more than one complexing agent for complexing copper ions comprises gluconic acid and/or salts thereof, most preferably the only complexing agent for complexing copper ions in the alkaline solution is gluconic acid and/or salts thereof.

Preferred is a method of the present invention, wherein in the alkaline solution the one or more than one complexing agent has a total concentration in a range from 5 mmol/L to 400 mmol/L, based on the total volume of the alkaline solution, preferably in a range from 10 mmol/L to 300 mmol/L, more preferably in a range from 15 mmol/L to 200 mmol/L, even more preferably in a range from 20 mmol/L to 100 mmol/L, yet even more preferably in a range from 25 mmol/L to 80 mmol/L, most preferably in a range from 30 mmol/L to 60 mmol/L. The aforementioned concentrations are preferably applicable to aforementioned preferred complexing agents, most preferably to gluconic acid and salts thereof.

The method of any of the preceding claims, wherein in step i-c the temperature of the aqueous alkaline solution is in a range from 20°C to 80°C, preferably in a range from 25°C to 75°C, more preferably in a range from 30°C to 70°C, even more preferably in a range from 35°C to 65°C, most preferably in a range from 40°C to 60°C.

In some embodiments of the present invention it is preferred if the aqueous alkaline solution used in step (i) additionally contains sodium chlorite or oxidising agent.

It has been found that step (i-c) can be applied as dip application. Dip application means that the solution is provided in form of a bath into which the copper, copper alloy or copper oxide are dipped. It has been further found that contact times of 40 s or longer are preferred. Preferably the contact time in step (i-c) is of from 40s to 900 s, more preferably the contact time in step (i-c) is of from 60 s to 500 s, even more preferably the contact time in step (i-c) is of from 90 s to 450 s.

In the alternative, i has been found that step (i-c) can be applied as spray application. Spray application means that the solution is transferred into a spray dispenser and then sprayed onto the copper, copper alloy or copper oxide. It has been further found that contact times of 10 s already yields good results. Hence, contact times of 10 s or longer are preferred. Preferably the contact time in step (i-c) is of from 20s to 200 s, more preferably the contact time in step (i-c) is of from 30 s to 150 s.

Method comprising step (II) - Applying Silane compounds

According to another embodiment of the instant invention, above mentioned objective is solved by a method for increasing adhesion strength and/or improved wedge void behavior between a surface of copper, a copper alloy or a copper oxide and a surface of an organic material comprising

(i) providing a substrate, comprising the copper, copper alloy or copper oxide on at least one side of the substrate, followed by the step of

(ii) contacting at least one section of the substrate with

(a) at least one silane compound of formula (I);

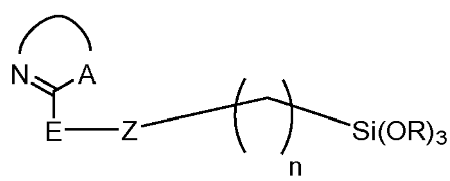

(I)

wherein

the ring structure

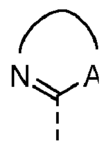

is selected from the group consisting of

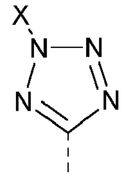 , 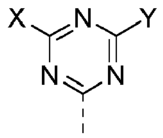 , 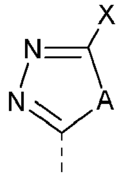

and mixtures thereof;

X and Y are independently selected from the group consisting of $NH_2$, $NH(NH_2)$, $NH(CH_2)_oNH_2$, SH, $SCH_3$, and $OCH_3$;

E is selected from the group consisting of-S- , -NH- and $-NH-(CH_2)_m-NH-$;

A is selected from the group consisting of NH, $N(NH_2)$ and S;

Z is selected from the group consisting of

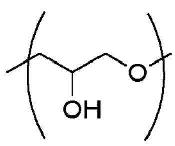 and 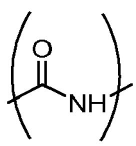 ,

m is an integer in the range from 2 to 12,

n is an integer in the range from 1 to 12,

o is an integer in the range from 2 to 12,

R independently denotes $(CH_2-CH_2-O)_p-T$, wherein independently

p is 0, 1, 2, 3, or 4, and

T denotes H or C1 to C5 alkyl; or

(b) at least one amino acid; or

a mixture of (a) and (b),

wherein, if both steps (i-c) and (ii) are performed, step (1-c) is performed prior to step (ii);

(iii) applying the organic material.

The contacting in step (ii) can be applied as dip application. Dip application means that the solution is provided in form of a bath into which the copper, copper alloy or copper oxide are dipped.

In the alternative, step (ii) can be applied as spray application. Spray application means that the solution is transferred into a spray dispenser and then sprayed onto the copper, copper alloy or copper oxide.

In the alternative, step (ii) can be applied as coating application such as bar coating, spin coating and curtain coating.

The method according to the invention is preferably performed at temperatures of from 5°C to 60°C, more preferably from 10°C to 40°C, even more preferably from 20°C to 30°C.

Triazine silane compounds

One embodiment of the inventive method refers to a specific triazine silane compound as defined above. In many cases a triazine silane compound of the present invention is preferred, wherein Y denotes NH and $N(NH_2)$,

preferably NH. In other cases a triazine silane compound of the present invention is preferred, wherein Y denotes S. Among both, a Y comprising a nitrogen is preferred compared to a Y being S.

A triazine silane compound of the present invention is preferred, wherein X denotes $NH_2$, $NH(NH_2)$, $NH(CH_2)_oNH_2$, SH, $SCH_3$, or $OCH_3$, wherein o is an integer in the range from 2 to 12; preferably $NH_2$, $NH(NH_2)$, $NH(CH_2)_oNH_2$, SH, or $SCH_3$, wherein o is an integer in the range from 2 to 12; more preferably $NH_2$.

Very preferred is a triazine silane compound of the present invention, being a compound of formula (II)

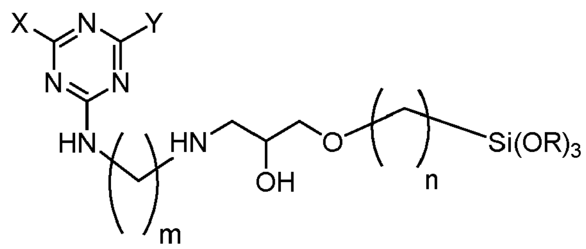

(II)

wherein

m is an integer in the range from 2 to 10,

n is an integer in the range from 1 to 10,

R independently denotes $(CH_2\text{-}CH_2\text{-}O)_p\text{-}T$, wherein independently

p is 0, 1, 2, 3, or 4, and
T denotes H or C1 to C5 alkyl.

Particularly preferred are compounds of formula (IIa) and (IIb).

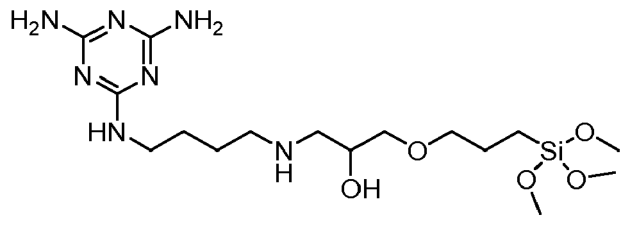

(IIa)

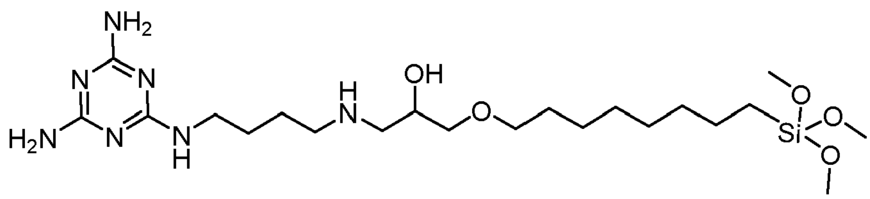

(IIb)

In the alternative, very preferred is a triazine silane compound of the present invention, being a compound of formula (III)

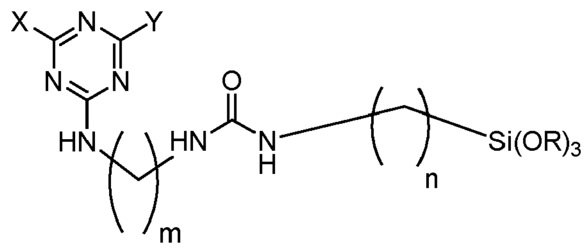

(III)

wherein

m is an integer in the range from 2 to 10,

n is an integer in the range from 1 to 10,

R independently denotes $(CH_2\text{-}CH_2\text{-}O)_p\text{-}T$, wherein independently

p is 0, 1, 2, 3, or 4, and

T denotes H or C1 to C5 alkyl.

Particularly preferred is a compound of formula (IIIa).

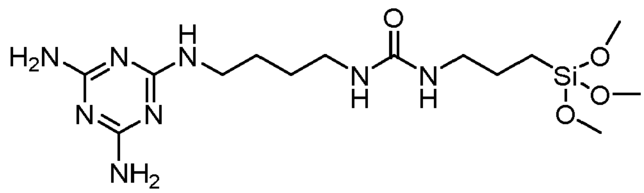

(IIIa)

In the context of the present invention the term "independently being" (or similar expressions) in combination with a certain variable denotes that a selected feature for such a variable in a first compound is independent from a selected feature of the same variable in a second compound and, if one compound contains the same variable at least twice, it is independently selected from each other, and thus can be different. This principle likewise applies to other "independently" terms.

Tetrazole silane compounds

One embodiment of the inventive method refers to a specific tetrazole silane compound as defined above. In many cases a tetrazole silane compound of the present invention of formula (IV) is preferred,

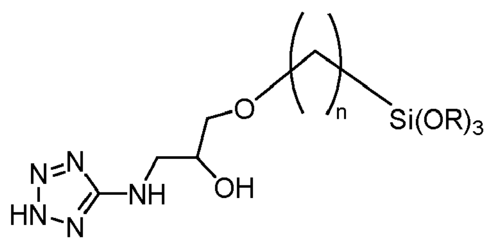

(IV)

wherein n is an integer in the range from 1 to 10,

R independently denotes ($CH_2$-$CH_2$-O) $_p$-T, wherein independently

p is 0, 1, 2, 3, or 4, and

T denotes H or C1 to C5 alkyl.

Very preferred is a tetrazole silane compound of the present invention, being a compound of formula (IVa)

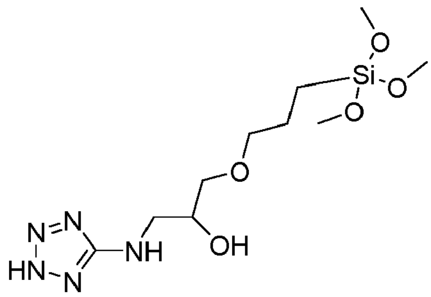

(IVa)

Triazole / Thiodiazole silane compounds

One embodiment of the inventive method refers to a specific triazole or a thiodiazole silane compound as defined above. In many cases a triazole or a thiodiazole silane compound of formula (V) is preferred,

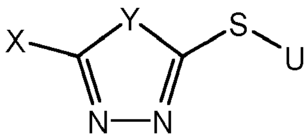

(V)

wherein

X denotes $NH_2$, $NH(NH_2)$, NH(NHU), $NH(CH_2)_oNH_2$, SH, $SCH_3$, $OCH_3$, NHU, or SU,

Y denotes NH, $N(NH_2)$, N(NHU), or S,

U independently denotes $CH_2$-CH(OH)-$CH_2$-O-$(CH_2)_n$-$Si(OR)_3$, with R independently being ($CH_2$-$CH_2$-O)$_p$-Z, wherein independently

n is an integer in the range from 1 to 10,

o is an integer in the range from 2 to 12,

p is 0, 1, 2, 3, or 4, and

Z denotes H or C1 to C5 alkyl.

Preferably, X denotes $NH_2$, $NH(NH_2)$, $NH(CH_2)_oNH_2$, SH, $SCH_3$, or $OCH_3$, wherein o is an integer in the range from 2 to 12; preferably $NH_2$, $NH(NH_2)$, $NH(CH_2)_oNH_2$, SH, or $SCH_3$, wherein o is an integer in the range from 2 to 12; more preferably $NH_2$.

Very preferred is a thiodiazole or triazole silane compound of the present invention, being a compound of formula (Va) or (Vb)

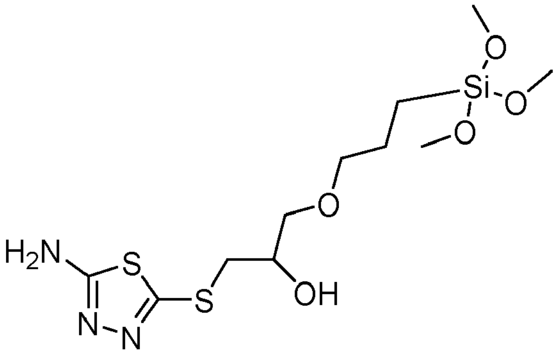

(Va)

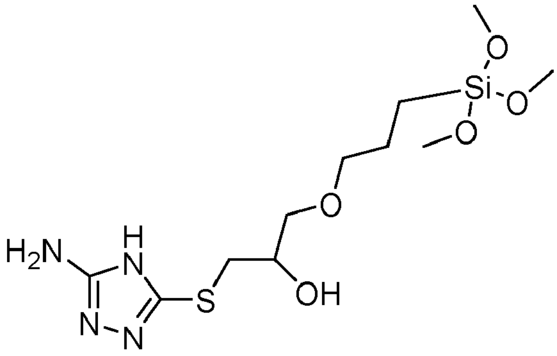

(Vb)

Synthesis of silane compounds

The synthesis of the triazine silane compounds is disclosed in co-pending application with the internal reference P21/002, which is incorporated by reference.

The synthesis of the triazole silane / thiodiazol compounds is disclosed in WO2019/243180, which is incorporated by reference.

A synthesis of tetrazole silane compounds has been disclosed in US 2020/0399290.

It was a further objective of the present invention to provide an alternative synthesis method of tetrazole silane compounds.

The present invention also relates to a synthesis method for a tetrazole silane compound of formula (IV):

A synthesis method for a tetrazole silane compound of formula (IV)

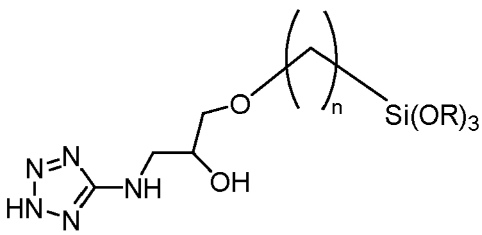

(IV)

wherein n is an integer in the range from 1 to 10,

R independently denotes $(CH_2-CH_2-O)_p-T$, wherein independently

p is 0, 1, 2, 3, or 4, and

T denotes H or C1 to C5 alkyl,

the synthesis method comprising the steps of

(i) providing a compound of formula (III)

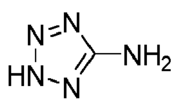

(VI),

(ii) providing a silane compound of formula (VII)

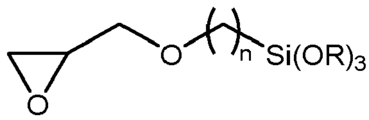

(VII),

wherein n is an integer in the range from 1 to 10,

R independently denotes $(CH_2-CH_2-O)_p$-T, wherein independently

p is 0, 1, 2, 3, or 4, and

T denotes H or C1 to C5 alkyl,

(iii) reacting in a solvent said compound of formula (VI) with said silane compound such that above defined compound of formula (IV) results, and

(iv) optionally hydrolyzing the compound of formula (IV) obtained in step (iii) such that at least one of R is $(CH_2-CH_2-O)_m$-Z with m = zero and Z = H.

The above mentioned regarding the tetrazole silane compound of the present invention (preferably as described as being preferred) preferably applies likewise to the synthesis method of the present invention, e.g. regarding very preferred tetrazole silane compounds of the present invention.

Step (iv) is optional and includes the presence of at least some water in order to hydrolyze the compound obtained in step (iii) of the method of the present invention. Preferably, such water is added after step (iii) in an additional step, e.g. step (iv). If such a compound is desired (m = zero and Z = H), step (iv) is not optional.

Very preferred is a synthesis method of the present invention, wherein in step (iii) the solvent comprises an organic solvent, more preferably is one or more than one organic solvent, most preferably is one or more than one water miscible organic solvent.

In many cases a synthesis method of the present invention is preferred, wherein in step (iii) the solvent is one or more than one solvent selected from the group consisting of glycol ethers, and mixtures thereof, preferably selected from the group consisting of

- $HO-(CH_2-CH_2-O)_p$-T,

wherein

p is 1, 2, 3, or 4, preferably is 1 or 2, and

T denotes C1 to C5 alkyl, preferably C3 to C5 alkyl,

and mixtures thereof, more preferably
selected from the group consisting of diethylene glycol monobutyl ether, ethylene glycol monobutyl ether, and mixtures thereof, even more preferably
selected from the group consisting of diethylene glycol monobutyl ether, ethylene glycol monobutyl ether, and mixtures thereof.

Generally, glycol ethers are more preferred than above defined alcohols (for reasons see text above). Thus, a respective synthesis method of the present invention is preferred.

Preferred is a synthesis method of the present invention (in particular as described before), wherein the solvent in step (iii) is substantially free of, preferably does not comprise, water.

Preferably, the solvent in step (iii) is one or more than one organic solvent and after step (iii) of the method of the present invention a mixture according to the present invention is obtained (for the mixture see text above). The aforementioned regarding the mixture of the present invention applies likewise to the synthesis method of the present invention.

Preferred is a synthesis method of the present invention, wherein the total molar ratio of the compound of formula (VI) to the compound of formula (VII) is in the range from 1:0.7 to 1:1.3, preferably in the range from 1:0.80 to 1:1.2, more preferably in the range from 1:0.9 to 1:1.2, most preferably in the range from 1:0.95 to 1:1.05. If the total molar ratio is significantly lower than 1:0.7 too much unreacted educts are present in the synthesis product, which is not desired because the desired species is the tetrazole silane compound comprising the tetrazole and the silane moiety. This principle preferably applies likewise to the mixture of the present invention, the storage solution of the present invention, and the working solution of the present invention.

Preferred is a synthesis method of the present invention, wherein in step (iii) the temperature is in the range from 50°C to 100°C, preferably in the range from 60°C to 90°C.

Preferred is a synthesis method of the present invention, wherein in step (i) the tetrazole compound of formula (III) is provided as a suspension. This means that it is preferred to suspend the tetrazole compound of formula (III) in at least one solvent such that said tetrazole compound and said at least one solvent form said suspension. For that it is preferred that the at least one solvent is one or more than one organic solvent, preferably is one or more than one water miscible organic solvent. Very preferably the at least one solvent utilized to form said suspension is identical to the solvent utilized in step (iii). Most preferred, the tetrazole compound of formula (III) is suspended in one or more than one solvent selected from the group consisting of C1 to C4 alcohols, glycol ethers, and mixtures thereof, preferably selected from the group consisting of

- C1 to C3 alcohols,
- cyclic and non-cyclic ethers such as diethyl ether, tetrahydrofuran, 1,4-dioxane, and mixtures thereof, preferably 1,4-dioxane, tetrahydrofuran and mixtures thereof,
- $HO-(CH_2-CH_2-O)_p-T$, wherein

  p is 1, 2, 3, or 4, preferably is 1 or 2, and

  T denotes C1 to C5 alkyl, preferably C3 to C5 alkyl,

and mixtures thereof, more preferably
selected from the group consisting of methanol, diethylene glycol monobutyl ether, ethylene glycol monobutyl ether, and mixtures thereof, most preferably
selected from the group consisting of diethylene glycol monobutyl ether, ethylene glycol monobutyl ether, and mixtures thereof.

Preferred is a synthesis method of the present invention, wherein in step (iii) the reacting is carried out for 1 hour to 48 hours, preferably for 3 hours to 30 hours, more preferably for 5 hours to 24 hours.

The method according to the invention is preferred, wherein the silane compound and, where applicable, the silane oligomer can be present as a mixture. Alternatively, more than one compound can be present as a mixture. Typically, an organic solvent facilitates solubility. Thus, the present invention also refers to a mixture comprising, preferably consisting of,

(a)

- one or more than one silane compound (as described throughout the present text, preferably as described as being preferred), and/or
- one or more than one silane oligomer (as described throughout the present text, preferably as described as being preferred),

(b)

- one or more than one organic solvent.

The method according to the invention is preferred, wherein the mixture of the present invention is substantially free of, preferably does not comprise, halide ions.

In the context of the present invention, the term "substantially free" of a subject-matter (e.g. a compound, a material, etc.) denotes that said subject-matter is not present at all or is present only in (to) a very little and undisturbing amount (extent) without affecting the intended purpose of the invention. For example, such a subject-matter might be

added or utilized unintentionally, e.g. as unavoidable impurity. "Substantially free" preferably denotes 0 (zero) ppm to 50 ppm, based on the total weight of the mixture (if defined for said mixture), preferably 0 ppm to 25 ppm, more preferably 0 ppm to 10 ppm, even more preferably 0 ppm to 5 ppm, most preferably 0 ppm to 1 ppm. Zero ppm denotes that a respective subject-matter is not comprised at all, which is most preferred. This principle applies likewise to other aspects of the present invention, e.g. the storage solution of the present invention (see text below) and the working solution of the present invention (see also text below).

Preferred is a method of the present invention, wherein in said mixture the total amount of all silane compounds of the present invention and oligomers of the present invention together is in the range from 5 wt.-% to 30 wt.-%, based on the total weight of said mixture, preferably is in the range from 8 wt.-% to 26 wt.-%, more preferably is in the range from 12 wt.-% to 24 wt.-%, even more preferably is in the range from 15 wt.-% to 23 wt.-%, most preferably is in the range from 17 wt.-% to 21 wt.-%.

Preferred is a method of the present invention, wherein the one or more than one organic solvent of the mixture comprises a solvent selected from the group consisting of acetone, 1,3-dioxolane, acetonitrile, 1,4-dioxane, methanol, ethanol, 1-propanol, 2-propanol, t-butanol, prop-2-en-1-ol, ethyl lactate, ethylene glycol monomethyl ether acetate, N,N-dimethylformamide, 2-butoxyethanol, di(propylene glycol) methyl ether, tetrahydrofurfuryl alcohol, N-methyl-2-pyrrolidone, 2-(2-methoxyethoxy)ethanol, gamma-butyrolactone, ethylene glycol, propylene glycol, dipropylene glycol, epsilon-caprolactone, diethylene glycol monobutyl ether, ethylene glycol monobutyl ether, tetrahydrothiophene-1-oxide, diethylene glycol monobutyl ether acetate, propylene carbonate, sulfolane, glycerol, and mixtures thereof.

Very preferred is a method of the present invention, wherein the one or more than one organic solvent of the mixture comprises a solvent selected from the group consisting of methanol, ethanol, 1-propanol, 2-propanol, *t*-butanol, di(propylene glycol) methyl ether, ethylene glycol, propylene glycol, dipropylene glycol, diethylene glycol monobutyl ether, ethylene glycol monobutyl ether, and mixtures thereof.

In a few cases very preferred is a method mixture of the present invention, wherein the one or more than one organic solvent of the mixture comprises a solvent selected from the group consisting of glycol ethers, preferably selected from the group consisting of di(propylene glycol) methyl ether, diethylene glycol monobutyl ether, ethylene glycol monobutyl ether, and mixtures thereof.

The present invention also refers to a storage solution comprising

(a)

- one or more than one silane compound according to the present invention (as described throughout the present text, preferably as described as being preferred), and
- optionally one or more than one silane oligomer according to the present invention (as described throughout the present text, preferably as described as being preferred),

(b)

- optionally water,

(c)

- one or more than one water miscible organic solvent,

with the proviso that, if water is present, the pH is 9 or higher.

Preferably the storage solution of the present invention is substantially free of, preferably does not comprise, halide ions. Only in a few cases it is preferred that halide ions are present by intentionally adding halide ions, preferably by intentionally adding chloride ions.

Preferred is a storage solution of the present invention, wherein in the solution the total amount of all silane compounds according to the present invention (as described throughout the present text, preferably as described as being preferred) and all silane oligomers according to the present invention (as described throughout the present text, preferably as described as being preferred) together is in the range from 0.2 wt.-% to 30 wt.-%, based on the total weight of the storage solution, preferably is in the range from 0.5 wt.-% to 28 wt.-%, more preferably is in the range from 0,7 wt.-% to 25 wt.-%, even more preferably is in the range from 0,8 wt.-% to 22 wt.-%, most preferably is in the range from 0.9 wt.-% to 20 wt.-%.

Above described storage solution optionally contains water. Preferred is a storage solution of the present invention, wherein in the storage solution is alkaline and water is present in a total amount in the range from 10 wt.-%

to 80 wt.-%, based on the total weight of the storage solution, preferably in the range from 15 wt.-% to 78 wt.-%, more preferably in the range from 20 wt.-% to 76 wt.-%, even more preferably in the range from 33 wt.-% to 74 wt.-%, most preferably in the range from 38.6 wt.-% to 70 wt.-%.

The storage solution contains one or more than one water miscible organic solvent. Such an organic solvent facilitates the needed solubility of the respective silane compounds and its oligomers, particular if they are present at comparatively higher concentrations (e.g. up to and around 15 wt.-%, see text above). Thus, preferred is a storage solution of the present invention, wherein in said solution the one or more than one water miscible organic solvent is present in a total amount in the range from 5 wt.-% to 89.5 wt.-%, based on the total weight of the storage solution, preferably in the range from 10 wt.-% to 84.2 wt.-%, more preferably in the range from 14 wt.-% to 79 wt.-%, even more preferably in the range from 18 wt.-% to 65.5 wt.-%, most preferably in the range from 24 wt.-% to 59 wt.-%.

In many cases a storage solution of the present invention is preferred, wherein the total weight of water is lower than the total weight of all water miscible organic solvents.

As mentioned above, said storage solution is alkaline, if water is present. In the context of the present invention this means that the pH is 9 or higher. Preferred is a storage solution of the present invention, wherein the solution has a pH of 9.6 or more, preferably the pH is in the range from 10.5 to 14, more preferably the pH is in the range from 11 to 14, most preferably the pH is in the range from 12 to 14. If the pH is significantly below pH 9 the solubility of the silane compounds and its oligomers is reduced, even up to the point of undesired precipitation. An acidic pH is not suitable for storage purposes because at such a pH precipitation has been observed in many cases with comparatively high concentrations of silane compounds of the present invention and its corresponding oligomers. It is known from WO2019/243180 that for azole silanes, if the pH is significantly above 13, an undesired phase separation and degradation of the azole silane compounds is frequently observed. In contrast, the instant triazine silanes solutions exhibit a good phase stability at high pH values.

In addition, the instant silanes solutions exhibit a good stability, i.e. no phase separation and no degradation, in a broad temperature window. In particular, those solutions are stable from -5°C to 50°C.

In the context of the present invention, the pH is referenced to a temperature of 25°C.

In an alkaline storage solution of the present invention, the alkaline pH is obtained by preferably utilizing at least one alkaline hydroxide, most preferably by utilizing sodium hydroxide.

An alkaline pH does not only allow comparatively high concentrations of said silane compounds and its oligomers, respectively, in the storage solution. It furthermore strongly maintains the silane compounds of the present invention in its monomeric state and significantly reduces the formation of silane oligomers of the present invention. However, if such an oligomer is formed in the alkaline storage solution of the present invention, it is typically quickly hydrolyzed to form its monomeric forms due to the alkaline pH. In the storage solution of the present invention this is desired.

Preferred is a storage solution of the present invention, wherein in said solution the total weight of all silane compounds according to the present invention is higher than the total weight of all silane oligomers according to the present invention.

In some cases a storage solution of the present invention is preferred, wherein for at least 80 wt.-% of the total weight of all silane compounds according to the present invention Z is H and p is zero, preferably for at least 90 wt.-%, most preferably for at least 95 wt.-%. This means that in the storage solution the silane compound is mostly present in its hydrolyzed form comprising SiOH-groups.

Above mentioned storage solution is in particular suitable in order to transport and/or storage the one or more than one silane compound of the present invention. However, in order to utilize said compounds, for example as a surface treatment solution in the production of electronic parts, a respective working solution is preferred. Thus, the present invention further relates to a working solution having a pH in the range from 2 to 14, the solution comprising

(a)

- one or more than one silane compound according to the present invention (as described throughout the present text, preferably as described as being preferred), and/or
- one or more than one silane oligomer according to the present invention (as described throughout the present text, preferably as described as being preferred),

(b)

- optionally, water,

(c)

- one or more than one water miscible organic solvent,

wherein in said working solution the total amount of all silane compounds according to the present invention (as described throughout the present text, preferably as described as being preferred) and all silane oligomers according to the present invention (as described throughout the present text, preferably as described as being preferred) together is 10 wt.-% or less, based on the total weight of the working solution.

In particular preferred is a working solution of the present invention with the proviso that said working solution comprises at least one silane oligomer according to the present invention (as described throughout the present text, preferably as described as being preferred). This is in particular preferred for freshly prepared working solutions.

Above term "10 wt.-% or less" does not include zero wt.-%. This means that said total amount is always > 0 wt.-%, preferably at least 0.1 wt.-%.

Preferred is a working solution of the present invention, wherein in said working solution the total amount of all silane compounds according to the present invention (as described throughout the present text, preferably as described as being preferred) and all silane oligomers according to the present invention (as described throughout the present text, preferably as described as being preferred) together is in the range from 0.1 wt.-% to 6 wt.-%, based on the total weight of the working solution, preferably is in the range from 0.2 wt.-% to 5 wt.-%, more preferably is in the range from 0.3 wt.-% to 4 wt.-%, even more preferably in the range from 0.4 wt.-% to 3.7 wt.-%, most preferably is in the range from 0.5 wt.-% to 3.5 wt.-%.

Own experiments have shown that the individual presence of the one or more than one silane compound according to the present invention and the one or more than one silane oligomer according to the present invention varies over time. In a freshly prepared working solution typically the total weight of silane compounds of the present invention is higher than the total weight of silane oligomers of the present invention. However, over time upon utilizing the working solution the total weight of said silane oligomers drastically increases, possibly even up to the point that the total weight of said silane oligomers is higher than the total weight of said silane compounds. Furthermore, the handling of the working solution of the present invention also affects the total weights of said compounds and oligomers, respectively. For example, a significant drag out during utilizing the working solution and a corresponding replenishment with fresh working solution typically leads to a steady state condition in terms of silane compound(s) vs. silane oligomer(s).

Most preferably, the working solution of the present invention comprises

- one or more than one silane compound according to the present invention (as described throughout the present text, preferably as described as being preferred), and

- one or more than one silane oligomer according to the present invention (as described throughout the present text, preferably as described as being preferred). Thus, a respective working solution comprising at least one compound and at least one oligomer is most preferred.

The working solution of the present invention has a pH in the range from 2 to 14. Preferred is a working solution of the present invention, wherein the pH is in the range from 3.5 to 14, more preferably in the range from 4.0 to 13.5.

Preferred is a working solution of the present invention, wherein in said solution water is present in a total amount in the range from 5 wt.-% to 90 wt.-%, based on the total weight of the working solution, preferably in a total amount in the range from 10 wt.-% to 85 wt.-%, more preferably in a total amount in the range from 15 wt.-% to 80 wt.-%.

In order to sufficiently solubilize the silane compounds of the present invention and the silane oligomers of the present invention in the working solution of the present invention, one or more than one water miscible organic solvent is present. Preferred is a working solution of the present invention, wherein in said solution the one or more than one water miscible organic solvent is present in a total amount in the range from 5 wt.-% to 90 wt.-%, based on the total weight of the working solution, preferably in a total amount in the range from 10 wt.-% to 85 wt.-%, more preferably in a total amount in the range from 15 wt.-% to 80 wt.-%.

As mentioned above, in the context of the present invention silane compounds of the present invention as well as silane oligomers of the present invention are initially free of halides. This means on the one hand that said compounds and oligomers, respectively, are in itself free of halide atoms because no educts containing halogen atoms are utilized, and on the other hand no halide ions are present in the immediate synthesis environment. However, in a few cases it is preferred that the working solution of the present invention comprises a precisely defined amount of halide ions. Therefore, in some cases a working solution of the present invention is preferred further comprising

(d)

- halide ions, preferably chloride ions.

However, in other cases it is preferred that the working solution of the present invention is substantially free of, preferably does not comprise, chloride ions, more preferably is substantially free of, preferably does not comprise, halide ions.

One or more than one water miscible organic solvent is present in both the storage solution of the present invention and the working solution of the present invention. Preferred is an storage solution according to the present invention (as described throughout the present text, preferably as described as being preferred), or a working solution according to the present invention (as described throughout the present text, preferably as described as being preferred), wherein the one or more than one water miscible organic solvent comprises a water-miscible organic solvent selected from the group consisting of C1 to C4 alcohols, ethers, glycol ethers, and mixtures thereof, preferably selected from the group consisting of

- C1 to C3 alcohols,
- cyclic and non-cyclic ethers such as diethyl ether, tetrahydrofuran, 1,4-dioxane, and mixtures thereof, preferably 1,4-dioxane, tetrahydrofuran and mixtures thereof,
- $HO-(CH_2-CH_2-O)_p-T$, wherein

  p is 1, 2, 3, or 4, preferably 1 or 2, and

  T denotes C1 to C5 alkyl, preferably C3 to C5 alkyl,

  and mixtures thereof, more preferably
  selected from the group consisting of methanol, diethylene glycol monobutyl ether, ethylene glycol monobutyl ether, and mixtures thereof, even more preferably
  selected from the group consisting of diethylene glycol monobutyl ether, ethylene glycol monobutyl ether, and mixtures thereof.

The above defined water-miscible organic solvents likewise apply to the synthesis method of the present invention (see text below).

In each case, glycol ethers are more preferred than alcohols. Glycol ethers typically provide an improved stabilization compared to said alcohols. Furthermore, alcohols in general exhibit a low flash point compared to glycol ethers, which makes alcohols potentially dangerous in terms of fire hazard. A comparatively high flash point is usually desired in order to prevent an ignition. Thus, glycol ethers typically provide the desired solubility, stability and security. This principle preferably applies likewise to the mixture of the present invention, the storage solution of the present invention, and the synthesis method of the present invention (see text below).

Preferred is a storage solution according to the present invention (as described throughout the present text, preferably as described as being preferred), or a working solution according to the present invention (as described throughout the present text, preferably as described as being preferred), wherein all silane compounds according to the present invention (as described throughout the present text, preferably as described as being preferred) and all silane oligomers according to the present invention (as described throughout the present text, preferably as described as being preferred) represent at least 70 wt.-% of the total weight of all silane compounds and oligomers in said storage solution and said working solution, respectively, preferably represent at least 80 wt.-%, more preferably represent at least 90 wt.-%, even more preferably represent at least 93 wt.-%, most preferably represent at least 95 wt.-%, even most preferably represent at least 98 wt.-%. It is most preferred that no other silane compounds or oligomers are present, except those according to the present invention. This also means that the absolute total amounts of silane compounds and silane oligomers together (as defined in the very text above) very preferably apply with the proviso that no other silane compounds and silane oligomers are present in the storage solution of the present invention and working solution of the present invention, respectively.

Furthermore, preferred is a storage solution according to the present invention (as described throughout the present text, preferably as described as being preferred), or a working solution according to the present invention (as described throughout the present text, preferably as described as being preferred), wherein all silane compounds according to the present invention (as described throughout the present text, preferably as described as being preferred) and all silane oligomers according to the present invention (as described throughout the present text, preferably as described as being preferred) represent at least 51 mol-% of all compounds comprising at least one silicon atom in said storage solution and said working solution, respectively, preferably represent at least 60 mol-%, more preferably represent at least 70 mol-%, most preferably represent at least 80 mol-%, even most preferably represent at least 90 mol-%.

Due to the method according to the invention the adhesion strength (e.g. peel strength) between a copper and

an organic material can be increased without using any etch-cleaning steps. But some cases - especially cases where a surface roughness of the copper surface does not affect the quality of the circuits - a further etch-cleaning step can be performed. In this case the adhesion strength between a copper and an organic material can be increased even further.

The method according to the invention is preferred, additionally comprising the following step before conducting step (ii): (i-a) contacting the at least one section of said copper, copper alloy or copper oxide with an etch-cleaning solution, preferably an etch-cleaning solution containing one or more than one acid and/or one or more than one oxidizing agent, more preferably an etch-cleaning solution containing a mixture of an inorganic acid and a peroxide (preferably a mixture of sulfuric acid and hydrogen peroxide).

According to the present invention it is preferred, when the oxidizing agent is a peroxide, more preferably when the peroxide is hydrogen peroxide.

According to the present invention it is preferred, when the etch-cleaning solution comprises in addition to the acid and/or to the one or more than one oxidizing agent a corrosion inhibitor.

The method according to the invention is preferred, additionally comprising the following step before conducting step (ii): (i-b) contacting the at least one section of said copper, copper alloy or copper oxide with a (preferably second) etch-cleaning solution. In case step (i-b) is carried out after step (i-a) the used etch-cleaning solution is the second etch-cleaning solution. In case step i-b is carried out without a previous etch-cleaning step, the used etch-cleaning solution is the first etch-cleaning solution.

According to the present invention the second etch-cleaning solution comprises an iron (III) salt or an iron (III) complex, more preferably the second etch-cleaning solution comprises ferric sulfate ($Fe_2(SO_4)_3$), ferric chloride ($FeCl_3$), bromide, ferric ($FeBr_3$), ferric nitrate ($Fe(NO_3)_3$), ferric acetate ($Fe(OC(O)CH_3)_3$), ($Fe(OH)_3$), or mixtures thereof, even more preferably the second etch-cleaning solution comprises ferric sulfate ($Fe_2(SO_4)_3$). The Ferric ion is preferably contained at a concentration in the range of 1 to 100 g/l, preferably from 1 to 50 g/l, and more preferably from 1 to 30 g/l.

In an alternative, according to the present invention the second etch-cleaning solution comprises an inorganic acid, more preferably the second etch-cleaning solution comprises sulfuric acid, hydrochloric acid or mixtures thereof, even more preferably the second etch-cleaning solution comprises sulfuric acid.

According to the present invention, a typical copper, copper alloy or copper oxide removal during step i-a is less than 2 $\mu$m, preferably, the removal is of from 0.1 $\mu$m to 1.5 $\mu$m, more preferably, the removal is of from 0.2 $\mu$m to 1.2 $\mu$m, even more preferably, the removal is of from 0.4 $\mu$m to 1.1 $\mu$m, most preferably, the removal is of from 0.5 $\mu$m to 1.0 $\mu$m; and resulting average surface roughness Ra is a maximum of 100 nm.

According to the present invention, a typical copper, copper alloy or copper oxide removal during step i-b is less than 20 nm and resulting average surface roughness Ra is a maximum of 10 nm, preferably, a maximum of 5 nm.

The method according to the invention is preferred, additionally comprising the following step before conducting step (ii): (i-c) contacting the at least one section of said copper, copper alloy or copper oxide with a solution, preferably a sodium hydroxide solution. It is preferred if the solution contain copper complexing agents.

In some embodiments of the present invention it is preferred if the solution used in step i-c additionally contains sodium chlorite or oxidising agent. The use of sodium chlorite or oxidising agent in the solution used in step i-c is especially preferred if in step i-b no iron (III) salt or an iron (III) complex is used or if step i-b is not performed during the method according to the present invention.

The order of the steps (i-a), (i-b), and (i-c) may vary. The method according to the invention can be carried out in the following order: (i-a), (i-b), (i-c), or (i-a), (i-c), (i-b), or (i-b), (i-a), (i-c), or (i-b), (i-c), (i-a), or (i-c), (i-a), (i-b), or (i-c), (i-b), (i-a). The order (i-a), (i-b), (i-c) is preferred. It is also possible that none, one or two of the steps (i-a), (i-b), (i-c) are performed in the method according to the invention.

The method according to the invention is preferred, wherein the organic material applied in step (iii) is an organic polymer.

The method according to the invention is preferred, wherein the organic material is applied in step (iii) by laminating the organic material onto at least the contacted section of the copper, copper alloy or copper oxide.

The method according to the invention is preferred, comprising after step (iii) the additional step: (iv) subjecting the substrate and the organic material to a heat treatment with a temperature in the range from 142°C to 420°C, preferably in the range from 145°C to 300°C, more preferably in the range from 150°C to 220°C.

The method according to the invention is preferred, wherein after step (ii), after step (i-a), after step (i-b) and/or after step (i-c), a rinsing of the at least one section of the copper, copper alloy or copper oxide is performed, wherein the copper, copper alloy or copper oxide is preferably rinsed with water. It is preferred if the water that is used during rinsing after step (ii) has a pH-value in the range from 2 to 14, preferably 4 to 10, more preferably in the range from 5 to 9, even more preferably in the range from 6 to 8, most preferably in the range from 6.5 to 7.5.

The method according to the invention is preferred, wherein after step (ii), after step (i-a), after step (i-b) and/or after step (i-c), a drying of the at least one section of the copper, copper alloy or copper oxide is performed.

In the alternative, a method according to to the invention is preferred, wherein after step (ii), no baking of the at least one section of copper, copper alloy or copper oxide is performed. It could be shown (Table 4 below) that samples

that were yielded by avoiding of the baking step leads to improved halo formation when compared to samples that were subjected to baking.

A method according to the present invention is especially preferred comprising the following steps in this order:

(i) providing a substrate, comprising the copper, copper alloy or copper oxide on at least one side of the substrate,

(i-a) optionally contacting at least one section of said copper, copper alloy or copper oxide with an etch-cleaning solution, preferably an etch-cleaning solution containing one or more than one acid and/or one or more than one oxidizing agent, more preferably an etch-cleaning solution containing a mixture of an inorganic acid and a peroxide, and optionally followed by rinsing of the at least one section of the copper, copper alloy or copper oxide (preferably with water),

(i-b) optionally contacting the at least one section of said copper, copper alloy or copper oxide with a second etch-cleaning solution, wherein the second etch-cleaning solution preferably comprises ferric sulfate and/or sulfuric acid, and optionally followed by rinsing of the at least one section of the copper, copper alloy or copper oxide (preferably with water),

(i-c) optionally contacting the at least one section of said copper, copper alloy or copper oxide with an alkaline solution, and optionally followed by rinsing of the at least one section of the copper, copper alloy or copper oxide (preferably with water),

(ii) contacting of the at least one section of said copper, copper alloy or copper oxide with

(a) at least one silane compound of formula (I);

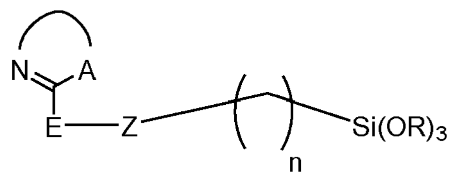

(I)

wherein
the ring structure

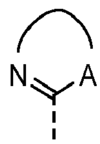

is selected from the group consisting of

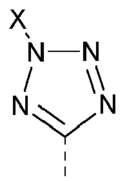 , 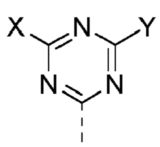 , 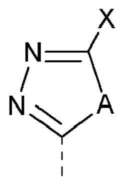

and mixtures thereof;
X and Y are independently selected from the group consisting of $NH_2$, $NH(NH_2)$, $NH(CH_2)_oNH_2$, SH, $SCH_3$, and $OCH_3$;
E is selected from the group consisting of-S- , -NH- and $-NH-(CH_2)_m-NH-$;
A is selected from the group consisting of NH, $N(NH_2)$ and S;

Z is selected from the group consisting of

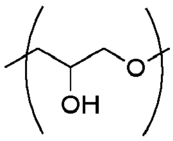 and 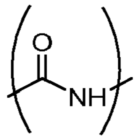,

m is an integer in the range from 2 to 12,
n is an integer in the range from 1 to 12,
o is an integer in the range from 2 to 12,
R independently denotes $(CH_2\text{-}CH_2\text{-}O)_p\text{-}T$, wherein independently
p is 0, 1, 2, 3, or 4, and
T denotes H or C1 to C5 alkyl; or
(b) at least one amino acid; or
a mixture of (a) and (b),
with the proviso that, if the ring structure

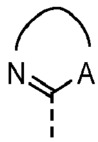

in the silane compound of formula (I) is

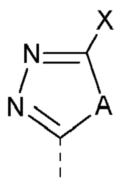,

both steps (i-c) and (ii) are performed,

and optionally followed by rinsing of the at least one section of the copper, copper alloy or copper oxide (preferably with water),
(iii) applying the organic material such that the at least one section of the copper, copper alloy or copper oxide contacted with the triazine silane compound and/or the triazine silane oligomer during step (ii) is in contact with the applied organic material,
and
(iv) optionally subjecting the substrate and the organic material to a heat treatment with a temperature in the range from 142°C to 420°C, preferably in the range from 145°C to 300°C, more preferably in the range from 150°C to 220°C.

A method according to the present invention is preferred, wherein the substrate is a non-conductive substrate and/or the organic material is a non-conductive organic material, preferably a non-conductive organic polymer.

The method according to the invention is preferred, wherein the method comprises both steps (i-c) and (ii). Hence, preferred is a method for increasing adhesion strength and/or improved wedge void behavior between a surface of copper, a copper alloy or a copper oxide and a surface of an organic material comprising

(i) providing a substrate, comprising the copper, copper alloy or copper oxide on at least one side of the substrate, followed by
(i-c) treating the substrate yielding a substrate comprising copper oxide on at least one side of the substrate, wherein the copper oxide comprises copper (I) and copper (II) in a ratio of 90:10 or higher (mol/mol), preferably in a ratio of 95:5 or higher (mol/mol), even more preferably in a ratio of 98:2 or higher (mol/mol), most preferably the copper oxide essentially consists of copper (I) oxide;
and

(ii) contacting at least one section of the substrate with

(a) at least one silane compound of formula (I);

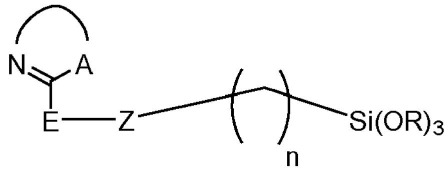

(I)

wherein
the ring structure

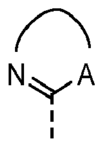

is selected from the group consisting of

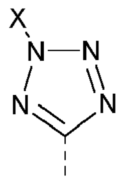 , 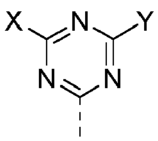 , 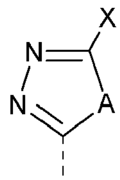

and mixtures thereof;
X and Y are independently selected from the group consisting of $NH_2$, $NH(NH_2)$, $NH(CH_2)_oNH_2$, SH, $SCH_3$, and $OCH_3$;
E is selected from the group consisting of-S- , -NH- and $-NH-(CH_2)_m-NH-$;
A is selected from the group consisting of NH, $N(NH_2)$ and S;
Z is selected from the group consisting of

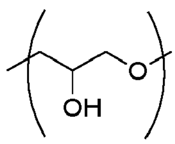 and 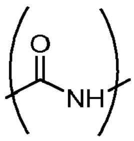 ,

m is an integer in the range from 2 to 12,
n is an integer in the range from 1 to 12,
o is an integer in the range from 2 to 12,
R independently denotes $(CH_2-CH_2-O)_p-T$, wherein independently
p is 0, 1, 2, 3, or 4, and
T denotes H or C1 to C5 alkyl; or

(b) at least one amino acid; or
a mixture of (a) and (b),

wherein, step (1-c-) is performed prior to step (ii);

(iii) applying the organic material.

Most preferred is a method wherein in step (ii) the at least one section of the substrate is contacted with both (a) a silane of formula (I) and (b) at least one amino acid.

Embodiments

A. A method for increasing adhesion strength and/or improved wedge void behavior between a surface of copper, a copper alloy or a copper oxide and a surface of an organic material comprising

(i) providing a substrate, comprising the copper, copper alloy or copper oxide on at least one side of the substrate, followed by at least one of the steps of
(i-c) treating the substrate yielding a substrate comprising copper oxide on at least one side of the substrate, wherein the copper oxide comprises copper (I) and copper (II) in a ratio of 90:10 or higher (mol/mol), preferably in a ratio of 95:5 or higher (mol/mol), even more preferably in a ratio of 98:2 or higher (mol/mol), most preferably the copper oxide essentially consists of copper (I) oxide;
and/or
(ii) contacting at least one section of the substrate with

(a) at least one silane compound of formula (I);

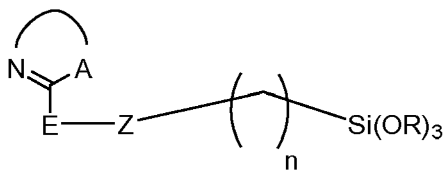

(I)

wherein
the ring structure

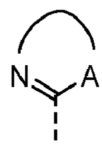

is selected from the group consisting of

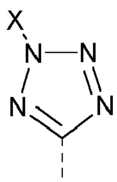 , 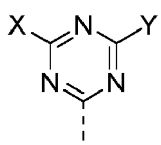 , 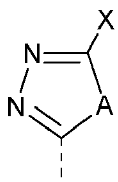

and mixtures thereof;
X and Y are independently selected from the group consisting of $NH_2$, $NH(NH_2)$, $NH(CH_2)_oNH_2$, SH, $SCH_3$, and $OCH_3$;
E is selected from the group consisting of-S- , -NH- and $-NH-(CH_2)_m-NH-$;
A is selected from the group consisting of NH, $N(NH_2)$ and S;
Z is selected from the group consisting of

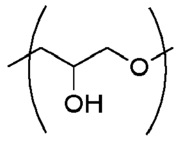 and 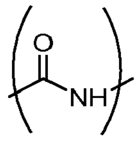 ,

m is an integer in the range from 2 to 12,
n is an integer in the range from 1 to 12,
o is an integer in the range from 2 to 12,
R independently denotes $(CH_2\text{-}CH_2\text{-}O)_p\text{-}T$, wherein independently
p is 0, 1, 2, 3, or 4, and
T denotes H or C1 to C5 alkyl; or
(b) at least one amino acid; or
a mixture of (a) and (b),

wherein, if both steps (i-c) and (ii) are performed, step (1-c-) is performed prior to step (ii);
(iii) applying the organic material,
with the proviso that, if the ring structure

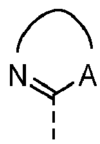

in the silane compound of formula (I) is

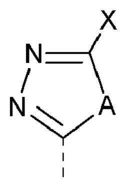 ,

both steps (i-c) and (ii) are performed.

B. The method according to embodiment A, wherein step (i-c) comprises contacting at least one section of said copper, copper alloy or copper oxide with an aqueous alkaline solution comprising one or more than one complexing agent; preferably the one or more than one complexing agent comprising at least one carboxylic group and at least one hydroxyl group; more preferred, the one or more than one complexing agent comprising a sugar, preferably a monomeric sugar; even more preferred the one or more than one complexing agent for complexing copper ions comprising gluconic acid and/or salts thereof; most preferably the only complexing agent for complexing copper ions in the alkaline solution is gluconic acid and/or salts thereof.

C. The method according to embodiment B, wherein the aqueous alkaline solution in step (i-c) has a pH in the range of from 7.5 to 14.0, preferably in the range of from 10.0 to 14.0.

D. The method according to embodiment B or C, wherein step (i-c) is applied as dip application and the contact time is 40 s or longer, preferably the contact time in step (i-c) is of from 40s to 900 s, more preferably the contact time in step (i-c) is of from 60 s to 500 s, even more preferably the contact time in step (i-c) is of from 90 s to 450 s.

E. The method according to embodiment B or C, wherein step (i-c) is applied as spray application and the contact time is 10 s or longer, preferably the contact time in step (i-c) is of from 20s to 200 s, more preferably the contact time in step (i-c) is of from 30 s to 150 s.

F. The method according to any of the preceding embodiments comprising the step of

(ii) contacting at least one section of the substrate with

(a) at least one silane compound of formula (I);

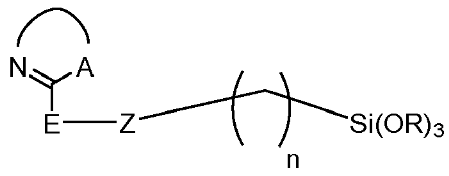

(I)

wherein
the ring structure

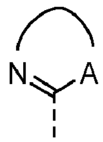

is selected from the group consisting of

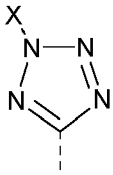

and

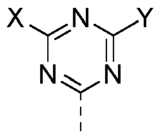

and mixtures thereof;
X and Y are independently selected from the group consisting of $NH_2$, $NH(NH_2)$, $NH(CH_2)_oNH_2$, SH, $SCH_3$, and $OCH_3$;
E is selected from the group consisting of-S- , -NH- and $-NH-(CH_2)_m-NH-$;
Z is selected from the group consisting of

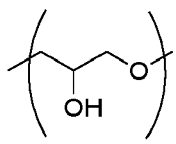

and

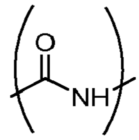

,

m is an integer in the range from 2 to 12,
n is an integer in the range from 1 to 12,
o is an integer in the range from 2 to 12,
R independently denotes $(CH_2-CH_2-O)_p-T$, wherein independently
p is 0, 1, 2, 3, or 4, and
T denotes H or C1 to C5 alkyl; or

(b) at least one amino acid; or
a mixture of (a) and (b).

G. The method according to any of the preceding embodiments, wherein the organic material applied in step (iii) is an organic polymer.

H. The method according to any of the preceding embodiments, wherein the organic material is applied in step (iii) by laminating the organic material onto at least the contacted section of the copper, copper alloy or copper oxide.

I. The method according to any of the preceding embodiments, if a step (ii) is performed, additionally comprising the following step before conducting step (ii):
(i-a) contacting the at least one section of said copper, copper alloy or copper oxide with an etch-cleaning solution, preferably an etch-cleaning solution containing one or more than one acid and/or one or more than one oxidizing agent, more preferably an etch-cleaning solution containing a mixture of an inorganic acid and a peroxide.

J. The method according to any of the preceding embodiments, if a step (ii) is performed, additionally comprising the following step before conducting step (ii):
(i-b) contacting the at least one section of said copper, copper alloy or copper oxide with a (preferably second) etch-cleaning solution, preferably comprising an inorganic acid, preferably sulfuric acid.

K. The method according to any of the preceding embodiments, wherein after step (ii), after step (i-a), after step (i-b) and/or after step (i-c), a rinsing of the at least one section of the copper, copper alloy or copper oxide is performed, wherein the copper, copper alloy or copper oxide is preferably rinsed with water.

L. The method according to any of the preceding embodiments A to K, wherein after step (ii), after step (i-a), after step (i-b) and/or after step (i-c), a drying of the at least one section of copper, copper alloy or copper oxide is performed.

M. The method according to any of the preceding embodiments A to K, wherein after step (ii), no baking of the at least one section of copper, copper alloy or copper oxide is performed.

N. The method according to any of the preceding embodiments, comprising after step (iii) the additional step:
(iv) subjecting the substrate and the organic material to a heat treatment with a temperature in the range from 142°C to 420°C, preferably in the range from 145°C to 300°C, more preferably in the range from 150°C to 220°C.

O. The method according to any of the preceding embodiments, wherein after step (ii), after step (i-a), after step (i-b) and/or after step (i-c), a rinsing of the at least one section of the copper, copper alloy or copper oxide is performed, wherein the copper, copper alloy or copper oxide is preferably rinsed with water.

P. The method according to any of the preceding embodiments, wherein the contacting time in step (ii) is from 5 seconds to 30 minutes, preferably from 7 seconds to 20 minutes, more preferably from 10 seconds to 10 minutes, even more preferably from 12 seconds to 5 minutes, most preferably from 15 seconds to 120 seconds.

Figures:

Figure 1: Top view SEM images (at different magnifications 2500x and 5000x) of copper foils treated after different immersion time in the alkaline treatment solution.

Figure 2: Ra and RSAI values obtained from AFM investigations of the copper foils after different process steps: initial, after Differential Etch DE, after alkaline treatment and after alkaline treatment +Silane coating.

Figure 3: Determined copper oxide thickness in nm formed on copper foils after different alkaline treatment time by integration of respective potential ranges with DSCV.

Figure 4: FTIR grazing incidence measurement-Peak integration of $Cu_2O$ signal by alkaline surface treatment time on copper foil. Integration performed over 683-616 $cm^{-1}$.

Figure 5: STEM image of Cu panel treated with an alkaline solution (300s dip) and coated with Silane. a) EDS analysis of oxide particles performed at three different areas. The small amounts of some elements are coming from the microscope: Mo→TEM-sample holder; Al, Zr→EDX detector, Pt, Ga→FIB Preparation, Fe, Co, Pb→TEM column.
b) STEM images at 200 mV, Nano-beam diffraction (NBD) line scan.

Figure 6: Example of halo measurement

The invention is further explained by the following non-limiting examples.

**Examples**

Synthesis of tetrazole silane compound of formula (IV):

Synthesis of tetrazole silane compound of formula (IV-a):

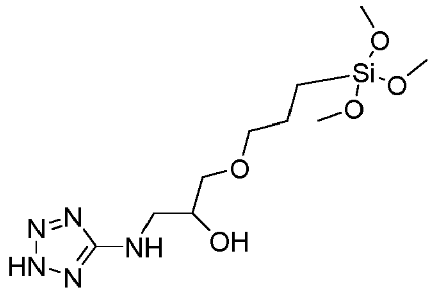

(IVa)

4,92 g (57,8 mmol) 2H-tetrazol-5-amine were suspended in 84,3 ml diethylene glycol monobutyl ether (DEGBE). This suspension was heated to 80°C. At that temperature 13.67 g (57,8 mmol) 3-glycidoxypropyltrimethoxysilane were added. The reaction mixture was kept at 80°C for 15hrs.

Afterwards, a reaction product with a concentration of approximately 20 wt.-% in DEGBE was obtained. The thus obtained product was utilized without further purification.

ESI-MS confirms the formation of a compound comprising three methoxy groups connected to the silicon atom. In addition, compounds comprising one, two, or three DEGBE moieties instead of respective methoxy groups also have been identified.

Sample preparation

Samples (each comprising several identical specimens) were prepared as follows.

Table 1 gives an overview on the reaction steps which are then described in more detail thereafter.

Table 1

| step | process | make up | Temp | Typical dwell time | remarks |
|---|---|---|---|---|---|
| (i) | Providing copper substrate | | | | |
| | Annealing (optional) | | 160°C | | Air ventilated oven, 1h |
| (i-a) | Differential Etch | 25ml/l Hyperflash 25<br>50ml/l $H_2SO_4$ 50%<br>65ml/l $H_2O_2$ 35% | 30°C | Depending on etch rate | Target etch depth is 0,5µm & 1µm |
| | Triple cascade Rinse | water | | | |
| | Dry (optional) | | | Up to dry | |
| (i-b) | $H_2SO_4$ 5% | 130ml/l $H_2SO_4$ 50% | ambient | 30 s | |
| | Triple cascade Rinse | water | ambient | 20 s | |
| (i-c) | aqueous alkaline solution | pH 14 | 50°C | 30-600s | |
| | Rinse | Water | ambient | 20 s | |

(continued)

| step | process | make up | Temp | Typical dwell time | remarks |
|---|---|---|---|---|---|
| | Dry (optional) | | | Up to dry | Hot air dryer, e.g. air gun, hair dryer |
| (ii) | Adhesion Promoter | Diff. Silanes | ambient | 60 s | See table with APs |
| | Triple cascade rinse | water | Ambient | 30s each | |
| | Dry | | | Up to dry | Hot air dryer, e.g. air gun, hair dryer |
| (ii-a) | Baking (optional) | | 130 | 30 min | Air ventilated oven |
| (iii) | Lamination | See Table 2 | | | |

Step (i):

Copper foils having a copper surface (150 mm x 75 mm x 35 μm, plated in house) were used. Under simplified laboratory conditions, copper foils without substrates are used for the examples.

For wedge void and or halo investigation plated copper panels were used.

The preparation conditions are as follows:

Electrolytically plated Copper type:

foil (adhesion test)

panels (wedge void)

Electrolyte:
Cupracid AC

Plating Parameters:

103min

1,5 A/dm$^2$ = 35μm plated Copper thickness

Step (i-a):

The copper surfaces of the copper foils were treated by 25ml/l Hyperflash 25, 50ml/l $H_2SO_4$ 50% and 65ml/l $H_2O_2$ 35% at 30°C to achieve 0.5 or 1μm etch depth. After the etch-cleaning the etch-cleaned copper surfaces were rinsed with water for approximately 30 seconds and optionally dried. As a result, etch-cleaned and rinsed copper surfaces were obtained.

Step (i-b):

The copper surfaces of the copper foils were cleaned at room temperature for 20-30 seconds by using a 5 vol% sulfuric acid.

Step (i-c):

The copper surfaces of the substrates were treated with aqueous alkaline solution (50 ° C, dipping, 300 sec or 50°C, spraying, 30 sec). After the treatment the treated copper surfaces of all copper foils were rinsed with cold water for approximately 30 seconds.

Step (ii):

Copper surfaces of the substrates were immersed for 60 sec at 25°C into a coating solution containing a triazine

silane compound and solvents. If water is present, the pH of the coating solution was 7 (triazole and tetrazole silanes) (adjusted with sulfuric acid, if needed) or up to 13.5 (triazine silanes). Details are given in Table 2.

Afterwards the resulting copper surfaces of all copper foils were rinsed with water for approximately 30 seconds and dried. As a result, silanized and dried copper surfaces of the copper foils were obtained.

Step (ii-a):

Copper foils were then annealed for 30 minutes at 130°C to remove remaining moisture from the surface. Note: this thermal treatment step is also known as baking. These substrates containing copper surfaces were subsequently subjected to laminating a build-up film (see text below).

Step (iii):

In a laminating step, an insulating film (see Table 2) was vacuum laminated onto the copper foils of all samples in a clean room with a room temperature in the range from 20 to 25°C and with a relative humidity of 50 to 60% by using a vacuum laminator.

The conditions for vacuum lamination were as follows: 100°C, vacuum: 30 sec. at 3 hPa, pressure: 30 sec at 0,5 MPa.

After lamination, laminated copper surfaces were obtained.

Table 2 - Overview Conditions

| Sample | Step (i-c) [no/dip/spray] | Time [s] | Step (ii) [yes/no] | silane | Time [s] |
|---|---|---|---|---|---|
| C1 (comparative) | no | n/a | No | n/a | n/a |
| 1a | dip | 30 | No | n/a | n/a |
| 1b | Spray | 30 | No | n/a | n/a |
| 2a | dip | 60 | No | n/a | n/a |
| 2b | Spray | 60 | No | n/a | n/a |
| 3a | dip | 120 | No | n/a | n/a |
| 3b | Spray | 120 | No | n/a | n/a |
| 4a | dip | 300 | No | n/a | n/a |
| 4b | Spray | 300 | No | n/a | n/a |
| 5 | dip | 30 | Yes | (IVa) | 60 s |
| 6 | dip | 60 | Yes | (IVa) | 60 s |
| 7 | dip | 120 | Yes | (IVa) | 60 s |
| 8 | dip | 300 | yes | (IVa) | 60 s |
| 9 | dip | 300 | yes | (Vb) | 60 s |
| 10 | dip | 300 | yes | (IIa) | 60 s |

(IVa): 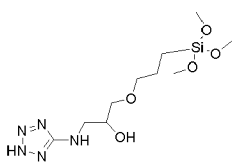

(Vb): 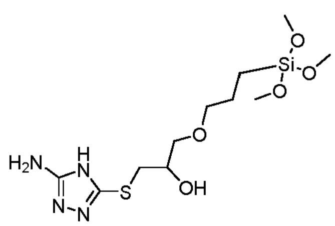

(IIa) 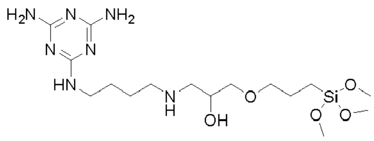

Surface morphology

The surface morphology was measured by means of Field Emission Scanning Electron Microscopy (FESEM). FEI NOVA Nanolab 600 and FEI Helios Nanolab 660 Microscopes were used to investigate surface as well as FIB prepared cross-sections.

SEM

Scanning Electron Microscopy (SEM) images show the change in the surface structure after step (i-c) at different times (Figure 1). At 30 s oxide particles formed on the surface (Sample 1). With longer treatment according to step (i-c) the Cu surface gets "flattened" caused by oxide particle growth.

AFM

Atomic Force Microscopy (AFM) was used to measure the surface roughness: for each sample, the surface was imaged on 5 measuring windows of 20 μm x 20 μm The average roughness $R_A$, and the relative surface area increase RSAI were calculated. Figure 2 depicts how the roughness increases by alkaline treatment and remains unchanged after application of silane.

Characterization of copper oxide

DSCV

The characterization of copper oxide was performed by means of Double- Sweep- Cyclic-Voltammetry (DSCV). Applied method used for Cu oxide quantification. During the first scan, cupric and cuprous oxides are reduced to Cu providing corresponding cathodic currents. Background currents are measured during the third scan in the same cathodic directions as the first scan. They are subtracted from the cathodic currents of the first scan in order to calculate the quantity of electrical charge required for the reduction of corresponding Cu oxide species. Experiments were performed il LiCl (4 M) solution at RT, potential range: -0.5 to -1.6 V (vs Ag/AgCl (3M KCl), Scan rates 100 mV/s, # of scans 3.

- For scan rate 100 mV/s:
  - CuO: -0.5 to -1.08 V(vs Ag/AgCl (3M KCl))
  - $Cu_2O$: -1.08 to -1.3 V (vs Ag/AgCl (3M KCl))
- Oxide layer thickness (d) nm was calculated using Faraday law:

$$d = \frac{Q \cdot M}{z \cdot F \cdot A \cdot \rho}$$

with $A$ =0.95 $cm^2$
$M(CuO)$ = 79.59 g/mol
$M(Cu_2O)$= 143.19 g/mol
$p(CuO)$ = 6.31 g/$cm^3$
$\rho(Cu_2O)$ = 6.00 g/$cm^3$
z =2
$F$ = 96485 C/mol

The measurement shows that Cu(II) oxide remains at the 'zero' level for the whole time. In contrast; Cu(I) oxide increased (Figure 3).

FTIR

Fourier-transform infrared spectroscopy (FTIR) with Grazing Incidence unit was used to characterize the substrate surface. The surface oxide state change during the alkaline treatment was evaluated. (Figure 4)

EDS

Elemental analysis of samples was carried out using Energy-dispersive X-ray spectroscopy (EDS). A lamella prepared for scanning transmission electron microscopy (STEM), and further used for the EDX measurements. Details are given in Figures 5 a) to c) and respective description.

EDS analysis was performed at three different areas of oxide particles

It has been found that, the ratio of Cu to O is 2 to 1, indicating that the oxide particles formed by alkaline solution are of $Cu_2O$ nature.

HRTEM

The nano-beam diffraction (NBD) measurements from high resolution transmission electron microscopy (HRTEM) mode is a most favorable technique for routine strain analysis (simple experimental set-up, nano-meter spatial resolution and high measurement sensitivity (std. dev. ~ 0.1%)).
The line scan was performed along the oxide particle height at nine positions. All obtained patterns are nearly identical → same quality oxide along the particle height is expected

Adhesion evaluation via peel strength test:

For selected samples obtained after the lamination, peel strength was determined:

(1) Initial,

(2) after 96 hours HAST (HAST conditions: 130°C, 85 % rh, HAST chamber: EHS-221M).

(3) after 12 cycles IR Reflow (thermal reliability, simulation of soldering process with temperature peak at 260 °C)

In order to determine the peel strength, several stripe-type fragments have been prepared from each specimen by adhering the respective copper foils to a rigid board (identical size as the copper foils) in such a way that the rigid board faced the insulating film. As a result, copper surfaces with structurally enforced insulating films were obtained.
The obtained copper surfaces with structurally enforced insulating films were then cured in an oven: copper surfaces with GL102 material at 200°C for 90 minutes and copper surfaces with GX-T31 material at 190 C for 90 min.
Afterwards, each copper surfaces with structurally enforced insulating films was sliced into said strip-type fragments (10x100 mm, Bugard drilling/routing).
The strip-type fragments were subjected to a peel force measuring machine (Roell Zwick Z010) to individually evaluate the peel strength (angle: 90°, speed: 50 mm/min) which is needed to delaminate the copper surface from its respective structurally enforced insulating films. Typically, the higher the peel strength needed to avoid delamination the better is the adhesion.
The peel strength of samples 1 to 15 are shown in Table 3 below.

Table 3

| Sample | Step (i-c) dipping [time in s] | Step (II) [silane] | Peel strength GX-T31 (N/cm) | | | Peel strength GL 102 (N/cm) | | |
|---|---|---|---|---|---|---|---|---|
| | | | Initial | HAST | Reflow | Initial | HAST | Reflow |
| C1 | n/a | n/a | 6,6 | 2,1 | 2,1 | 6,4 | 1,6 | 4,7 |
| 1a | 30 | n/a | 9.3 | 3.7 | 5.0 | 7,5 | 2,2 | 5,6 |
| 2a | 60 | n/a | 9.5 | 4.8 | 4.3 | 7,2 | 2,5 | 4,8 |
| 3a | 120 | n/a | 9.7 | 5.6 | 4.5 | 7,6 | 2,7 | 5,2 |

(continued)

| Sample | Step (i-c) dipping [time in s] | Step (II) [silane] | Peel strength GX-T31 (N/cm) | | | Peel strength GL 102 (N/cm) | | |
|---|---|---|---|---|---|---|---|---|
| | | | Initial | HAST | Reflow | Initial | HAST | Reflow |
| 4a | 300 | n/a | 10.2 | 5.8 | 4.8 | 7,9 | 3.3 | 5.6 |
| C2 | n/a | (Vb) | | | | 7,5 | 4,4 | |
| 5 | n/a | (IVa) | 5.8 | 2.8 | 3.0 | 7.2 | 2.4 | 6.3 |
| 6 | n/a | (IIa) | 8.4 | 4.0 | 5.0 | 6.8 | 3.6 | 5.7 |
| 7 | 30 | (IVa) | 8.6 | 2.9 | 4.0 | 6.1 | 2.9 | 5.8 |
| 8 | 60 | (IVa) | 8.8 | 4.7 | 4.5 | 6.8 | 4.3 | 6.2 |
| 9 | 120 | (IVa) | 10.2 | 5.6 | 5.6 | 6.9 | 4.9 | 6.5 |
| 10 | 300 | (IVa) | 9.8 | 8.3 | 7.5 | 7.3 | 4.8 | 6.3 |
| 11 | 300 | (Vb) | | | | 7,3 | 4,6 | |
| 12 | 30 | (IIa) | 8.7 | 6.5 | 6.2 | 6.3 | 3.8 | 5.8 |
| 13 | 60 | (IIa) | 8.9 | 7.4 | 7.2 | 6.5 | 4.2 | 5.8 |
| 14 | 120 | (IIa) | 9.5 | 7.8 | 7.4 | 6.7 | 4.7 | 6.2 |
| 15 | 300 | (IIa) | 9.4 | 8.5 | 7.8 | 7.5 | 5.0 | 6.5 |

(IVa): 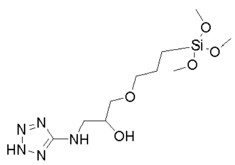

(Vb): 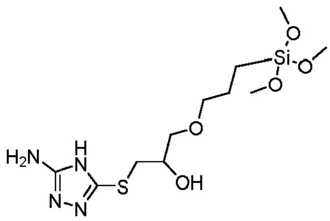

(IIa) 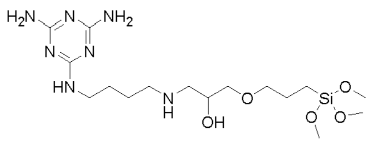

The experiments show that the inventive examples exhibit a good adhesion strength, here expressed as peel strength.

<u>Halo and wedge void evaluation</u>

Sample preparation:

In order to evaluate the halo, the copper samples have been prepared by adhering the respective insulating films to copper panels. As a result, copper surfaces with structurally enforced insulating films were obtained.

The obtained copper surfaces with structurally enforced insulating films were then semicured in two steps in the ovens: copper surfaces with GL102 material at 130°C for 30 minutes followed by 175°C for 30 minutes; and copper surfaces with GX-T31 material at 100°C for 30 minutes followed by 170°C for 30 minutes.

After completing the lamination and semi-curing step, the copper panels were lasered with UV-laser to drill the blind micro vias (BMV). Thereafter, the substrates were subjected to the desmear and reduction condition steps. In particular, these included a sweller treatment under alkaline conditions with Securiganth MV Sweller (Atotech); a permanganate treatment under alkaline conditions with Securiganth MV Etch P (Atotech) and a reduction conditioner treatment under acidic conditions with Securiganth MV Reduction Conditioner (Atotech). After each step the sample were rinsed with water.

The lamination material exhibits a thickness of ca. 10 μm for wedge void and halo and 35 μm in case of adhesion investigations, respectively.

Measurements:

1) Halo Evaluation

The substrates were measured by light microscope (200x magnification; see Table 4). Pictures depicting the halo measurement can be found in Figure 6.

The investigated test Blind Micro Via's (BMV) are manufactured as a test grid on surface treated and Ajinomoto Build up Film (ABF) laminated test vehicles by utilizing Laser Drilling technology. The halo data is obtainable after sending the prepared test vehicles through entire Desmear process (Sweller, Permanganate, Reduction Conditioner) as described above.

Halo measurement is performed by camera (CCD) supported light microscopy. Hereby, the microscope must be operated in epi-illumination mode. All image generation must be carried out by using Darkfield (DF) filter setting. A magnification factor of approx. 200x is typically used.

The fully processed test vehicles are firmly installed on the measurement table and the BMV capture pad must be set as optical focus. CCD exposure time must be adjusted to the maximum possible contrast of halo boundaries. Hereby, the capture pad should appear as bright as possible.

The visible diameter of the via hole (or clean capture pad), the inner (innermost) and the outer (outermost) appearing halo like boundaries are measured and recorded according to Figure 6. The actual halo values can now be calculated by using following relations.

1.

$$\text{Outer Halo}(\mu m) = (\text{Outermost Diameter}(\mu m) - \text{Diameter of Via Hole}(\mu m))/2$$

2.

$$\text{Inner Halo}(\mu m) = (\text{Inner Diameter of Halo}(\mu m) - \text{Diameter of Via Hole}(\mu m))/2$$

Typically, this process is iterated at least three times at random test vias to enable minimal statistical statements.

Table 4

| Sample | Step (i-c) dipping [time in s] | Step (II) [silane] | GL102 (μm halo size) With baking (130°C, 30 min) | | GL102 (μm halo size) Without baking | |
|---|---|---|---|---|---|---|
| | | | Inner | Outer | Inner | Outer |
| C1 | n/a | n/a | 79,9 | 143 | 49,6 | 91,8 |
| 2a | 60 | n/a | 61,9 | 104 | 39,7 | 71,2 |
| 4a | 300 | n/a | 19,2 | 61,7 | 17,9 | 38,6 |
| C2 (comparative) | n/a | (Vb) | 67.2 | 76.4 | | |
| 5 | n/a | (IVa) | 65 | 85 | 15 | 41 |
| 6 | n/a | (IIa) | 19,0 | 75 | 15 | 60 |
| 8 | 60 | (IVa) | 50 | 70 | n/a | n/a |
| 10 | 300 | (IVa) | 23.1 | 68.7 | 19.5 | 42.0 |
| 11 | 300 | (Vb) | 22.5 | 74.8 | | |
| 12 | 300 | (IIa) | 20.0 | 25 | | |

(IVa): 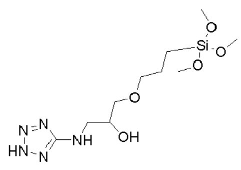

(Vb): 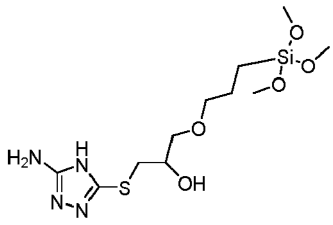

(IIa) 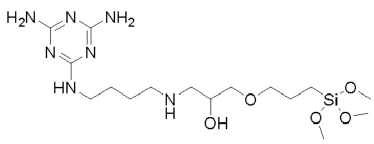

The best result is obtained for the combination of step (i-c) with step (ii) comprising T-E silane

The experiments show that the inventive examples exhibit a good behavior regarding avoidance of wedge void formation, here expressed as halo sizes.

2) Wedge void evaluation

In addition, substrates were subjected to Focused Ion Beam (FIB) cuts and subsequent Scanning Electron Microscopy (SEM) measurement. This method allows to analyze the copper adhesion in the vicinity of a blind micro via (BMV), also known as wedge void.

## Claims

**1.** A method for increasing adhesion strength and/or improved wedge void behavior between a surface of copper, a copper alloy or a copper oxide and a surface of an organic material comprising

(i) providing a substrate, comprising the copper, copper alloy or copper oxide on at least one side of the substrate, followed by at least one of the steps of
(i-c) treating the substrate yielding a substrate comprising copper oxide on at least one side of the substrate, wherein the copper oxide comprises copper (I) and copper (II) in a ratio of 90:10 or higher (mol/mol), preferably in a ratio of 95:5 or higher (mol/mol), even more preferably in a ratio of 98:2 or higher (mol/mol), most preferably the copper oxide essentially consists of copper (I) oxide;
and/or
(ii) contacting at least one section of the substrate with

(a) at least one silane compound of formula (I);

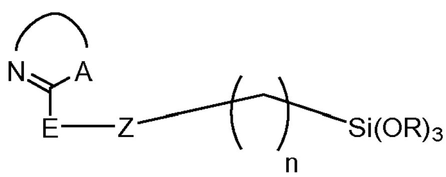

(I)

wherein
the ring structure

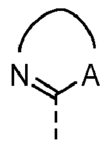

is selected from the group consisting of

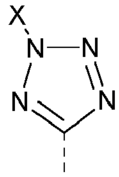 , 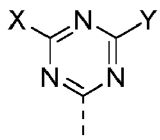 , 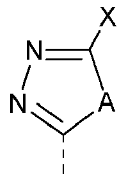

and mixtures thereof;
X and Y are independently selected from the group consisting of $NH_2$, $NH(NH_2)$, $NH(CH_2)_oNH_2$, SH, $SCH_3$, and $OCH_3$;
E is selected from the group consisting of-S- , -NH- and $-NH-(CH_2)_m-NH-$;
A is selected from the group consisting of NH, $N(NH_2)$ and S;
Z is selected from the group consisting of

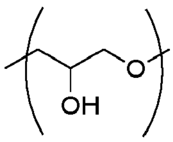 and 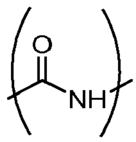 ,

m is an integer in the range from 2 to 12,
n is an integer in the range from 1 to 12,
o is an integer in the range from 2 to 12,
R independently denotes $(CH_2-CH_2-O)_p-T$, wherein independently
p is 0, 1, 2, 3, or 4, and
T denotes H or C1 to C5 alkyl; or
(b) at least one amino acid; or
a mixture of (a) and (b),

wherein, if both steps (i-c) and (ii) are performed, step (1-c-) is performed prior to step (ii);
(iii) applying the organic material, with the proviso that, if the ring structure

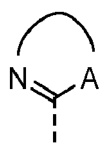

in the silane compound of formula (I) is

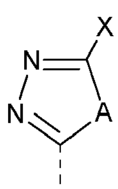 ,

both steps (i-c) and (ii) are performed.

2. The method according to claim 1, wherein step (i-c) comprises contacting at least one section of said copper, copperalloy or copper oxide with an aqueous alkaline solution comprising at least one complexing agent.

3. The method according to claim 2, wherein the aqueous alkaline solution in step (i-c) has a pH in the range of from 7.5 to 14.0, preferably in the range of from 10.0 to 14.0.

4. The method according to claim 2 or claim 3, wherein step (i-c) is applied as dip application and the contact time is 40 s or longer, preferably the contact time in step (i-c) is of from 40s to 900 s, more preferably the contact time in step (i-c) is of from 60 s to 500 s, even more preferably the contact time in step (i-c) is of from 90 s to 450 s.

5. The method according to claim 2 or claim 3, wherein step (i-c) is applied as spray application and the contact time is 10 s or longer, preferably the contact time in step (i-c) is of from 20s to 200 s, more preferably the contact time in step (i-c) is of from 30 s to 150 s.

6. The method according to any of the preceding claims comprising the step of

(ii) contacting at least one section of the substrate with

(a) at least one silane compound of formula (I);

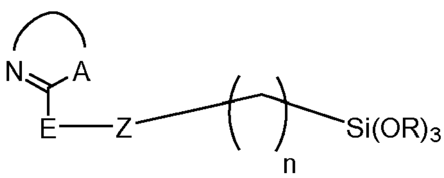

(I)

wherein
the ring structure

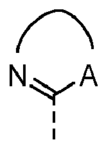

is selected from the group consisting of

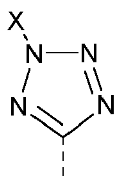

and

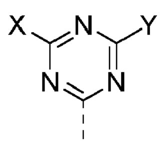

and mixtures thereof;
X and Y are independently selected from the group consisting of $NH_2$, $NH(NH_2)$, $NH(CH_2)_oNH_2$, SH, $SCH_3$, and $OCH_3$;
E is selected from the group consisting of -S- , -NH- and $-NH-(CH_2)_m-NH-$;
Z is selected from the group consisting of

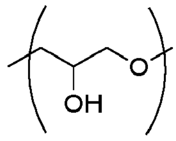 and 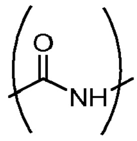 ,

m is an integer in the range from 2 to 12,
n is an integer in the range from 1 to 12,
o is an integer in the range from 2 to 12,
R independently denotes $(CH_2-CH_2-O)_p-T$, wherein independently
p is 0, 1, 2, 3, or 4, and
T denotes H or C1 to C5 alkyl; or
(b) at least one amino acid; or
a mixture of (a) and (b).

**7.** The method according to any of the preceding claims, wherein the organic material applied in step (iii) is an organic polymer.

**8.** The method according to any of the preceding claims, wherein the organic material is applied in step (iii) by laminating the organic material onto at least the contacted section of the copper, copper alloy or copper oxide.

**9.** The method according to any of the preceding claims, if a step (ii) is performed, additionally comprising the following step before conducting step (ii):
(i-a) contacting the at least one section of said copper, copper alloy or copper oxide with an etch-cleaning solution, preferably an etch-cleaning solution containing one or more than one acid and/or one or more than one oxidizing agent, more preferably an etch-cleaning solution containing a mixture of an inorganic acid and a peroxide.

**10.** The method according to any of the preceding claims, if a step (ii) is performed, additionally comprising the following step before conducting step (ii):
(i-b) contacting the at least one section of said copper, copper alloy or copper oxide with a (preferably second) etch-cleaning solution, preferably comprising an inorganic acid, preferably sulfuric acid.

**11.** The method according to any of the preceding claims, wherein after step (ii), after step (i-a), after step (i-b) and/or after step (i-c), a rinsing of the at least one section of the copper, copper alloy or copper oxide is performed, wherein the copper, copper alloy or copper oxide is preferably rinsed with water.

**12.** The method according to any of the preceding claims 1-11, wherein after step (ii), after step (i-a), after step (i-b) and/or after step (i-c), a drying of the at least one section of copper, copper alloy or copper oxide is performed.

**13.** The method according to any of the preceding claims 1-11, wherein after step (ii), no baking of the at least one section of copper, copper alloy or copper oxide is performed.

**14.** The method according to any of the preceding claims, comprising after step (iii) the additional step:
(iv) subjecting the substrate and the organic material to a heat treatment with a temperature in the range from 142°C to 420°C, preferably in the range from 145°C to 300°C, more preferably in the range from 150°C to 220°C.

**15.** The method according to any of the preceding claims, wherein after step (ii), after step (i-a), after step (i-b) and/or after step (i-c), a rinsing of the at least one section of the copper, copper alloy or copper oxide is performed, wherein the copper, copper alloy or copper oxide is preferably rinsed with water.

Figure 1

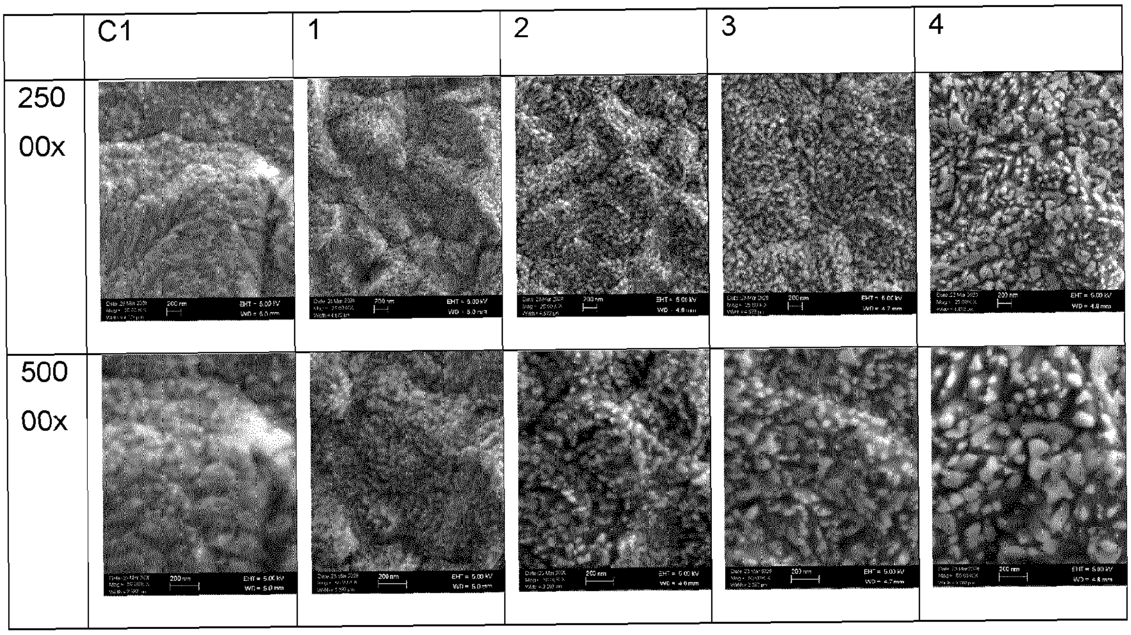


Figure 2

a)

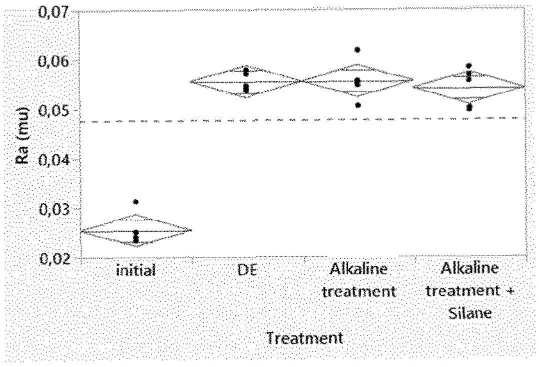


b)

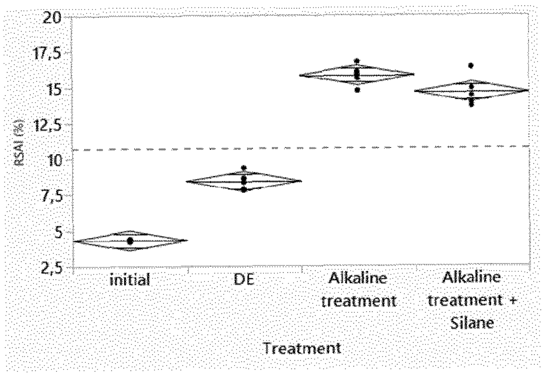


DE: Differential Etch: step (i-a)

Figure 3

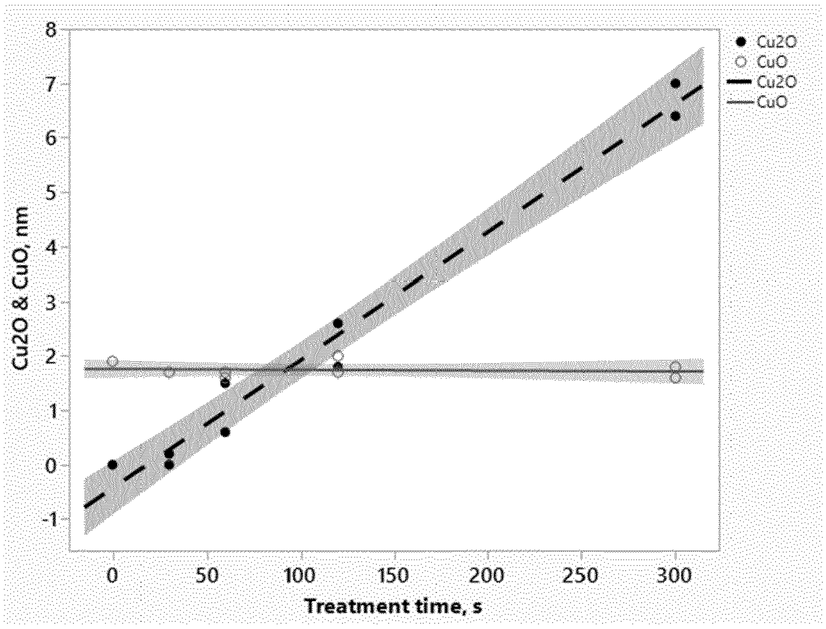


Figure 4

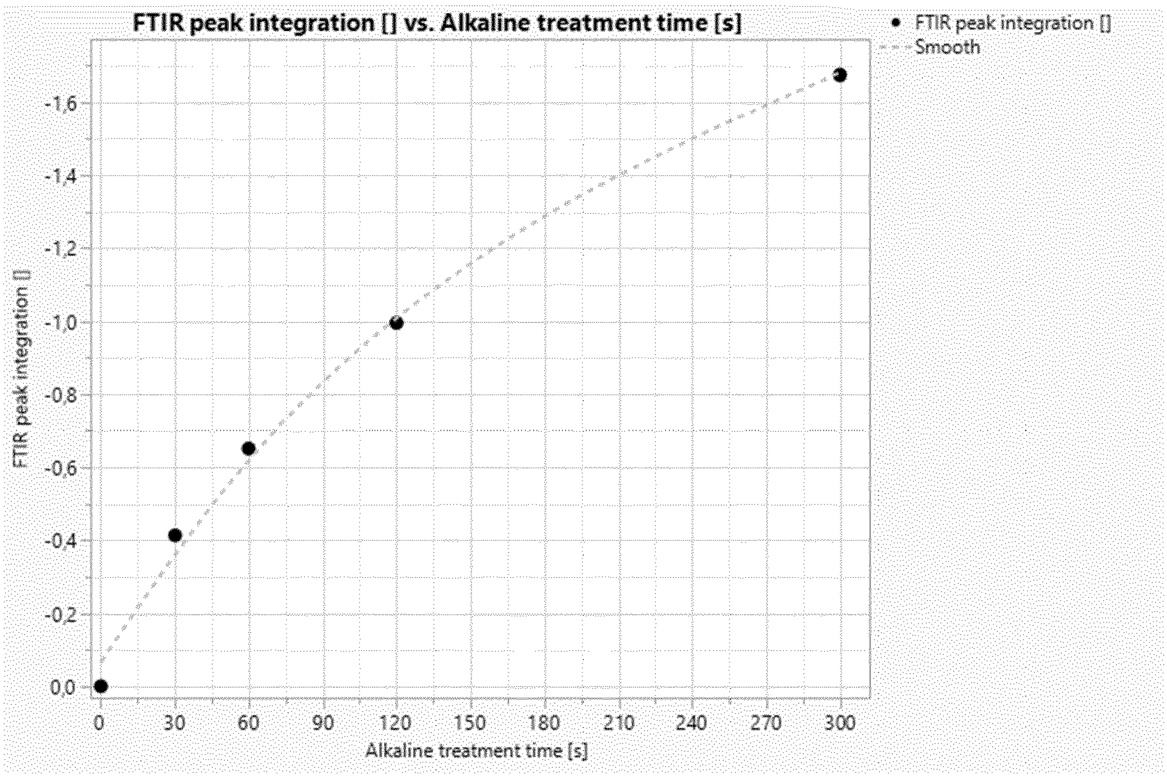

Figure 5

a)

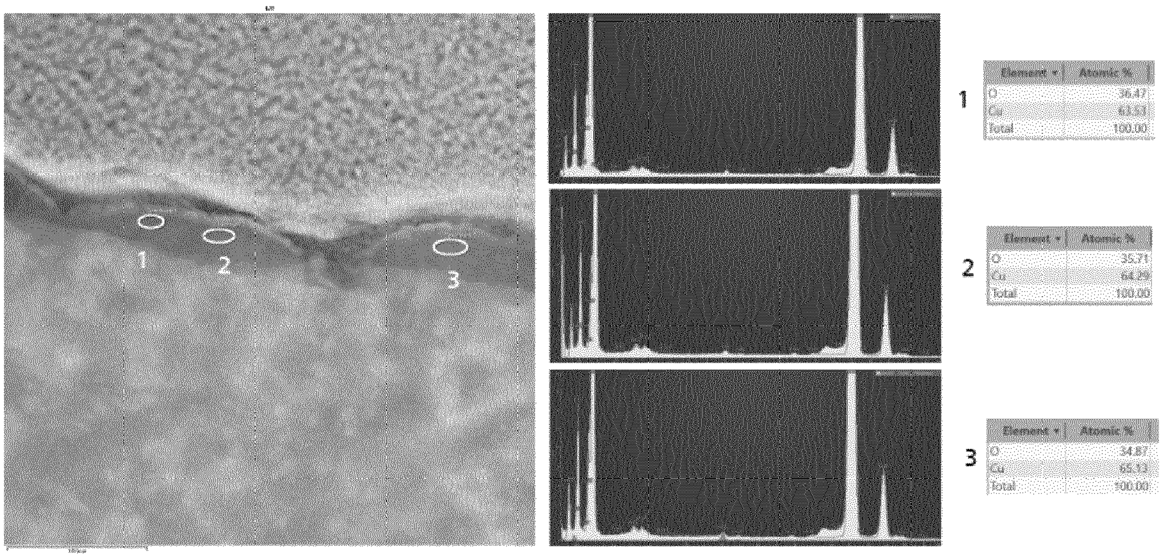
1
2
3
1
Element | Atomic %
O 36.47
Cu 63.53
Total 100.00
2
Element | Atomic %
O 35.71
Cu 64.29
Total 100.00
3
Element | Atomic %
O 34.87
Cu 65.13
Total 100.00

b)

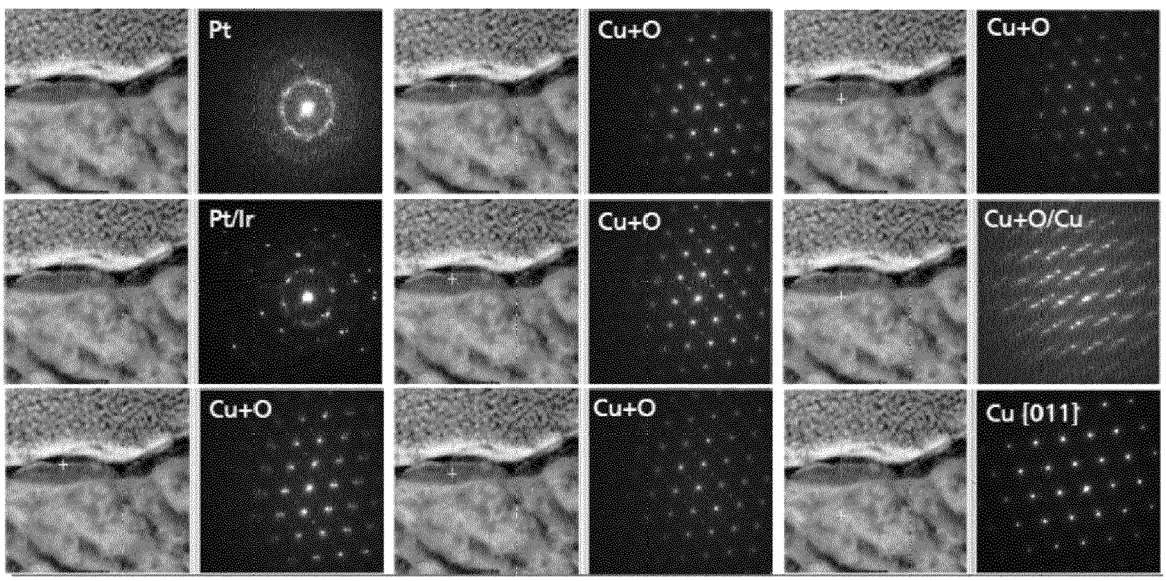
Pt
Cu+O
Cu+O
Pt/Ir
Cu+O
Cu+O/Cu
Cu+O
Cu+O
Cu [011]

Figure 6:

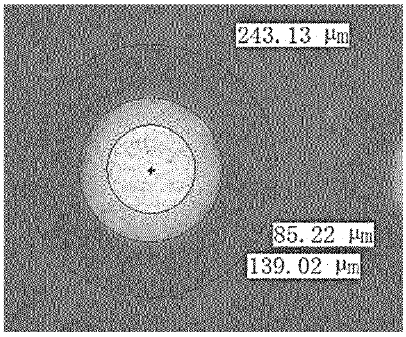

Europäisches Patentamt
European Patent Office
Office européen des brevets

# EUROPEAN SEARCH REPORT

Application Number
EP 21 16 2439

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br>Y | WO 2020/148308 A1 (ATOTECH DEUTSCHLAND GMBH [DE]) 23 July 2020 (2020-07-23)<br>* claims 1-3,8,11 *<br>* penultimate paragraph; page 1 *<br>* fourth and fifth paragraphs; page 5 *<br>* second and third paragraphs; page 6 *<br>* second paragraph; page 11 *<br>* fourth paragraph; page 13 *<br>* last paragraph; page 14 *<br>----- | 1-5,7,8, 11,12, 14,15<br><br>9 | INV.<br>H05K3/38 |
| X | JP 2015 092020 A (SHIKOKU CHEM) 14 May 2015 (2015-05-14)<br>* claims 3,10,11 *<br>* paragraphs [0052], [0055] *<br>----- | 1 | |
| X | JP 6 779557 B1 (MEC CO LTD) 4 November 2020 (2020-11-04)<br>* claim 1 *<br>* paragraphs [0002], [0038] *<br>----- | 1 | TECHNICAL FIELDS SEARCHED (IPC)<br>H05K |
| X | CN 107 190 254 A (BOMIN ELECTRONICS CO LTD) 22 September 2017 (2017-09-22)<br>* claim 1 *<br>* paragraph [0003] *<br>----- | 1 | |
| Y | JP 2017 048467 A (MITSUI MINING & SMELTING CO) 9 March 2017 (2017-03-09)<br>* paragraphs [0009], [0027], [0028], [0040], [0047], [0061] *<br>* examples 13-c; table 3 *<br>-----<br>-/-- | 1,6,9, 10,13 | |

The present search report has been drawn up for all claims

1

| Place of search | Date of completion of the search | Examiner |
|---|---|---|
| The Hague | 6 August 2021 | Dardel, Blaise |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 21 16 2439

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2007 131556 A (UNIV IWATE) 31 May 2007 (2007-05-31) * paragraph [0049]; example 11 * ----- | 1,6,9, 10,13 | |

TECHNICAL FIELDS SEARCHED (IPC)

The present search report has been drawn up for all claims

| Place of search | Date of completion of the search | Examiner |
|---|---|---|
| The Hague | 6 August 2021 | Dardel, Blaise |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 2 of 2

# ANNEX TO THE EUROPEAN SEARCH REPORT ON EUROPEAN PATENT APPLICATION NO.

EP 21 16 2439

This annex lists the patent family members relating to the patent documents cited in the above-mentioned European search report.
The members are as contained in the European Patent Office EDP file on
The European Patent Office is in no way liable for these particulars which are merely given for the purpose of information.

06-08-2021

| Patent document cited in search report | Publication date | Patent family member(s) | Publication date |
|---|---|---|---|
| WO 2020148308 A1 | 23-07-2020 | TW 202037758 A | 16-10-2020 |
| | | WO 2020148308 A1 | 23-07-2020 |
| JP 2015092020 A | 14-05-2015 | JP 6440440 B2 | 19-12-2018 |
| | | JP 2015092020 A | 14-05-2015 |
| JP 6779557 B1 | 04-11-2020 | CN 113026008 A | 25-06-2021 |
| | | JP 6779557 B1 | 04-11-2020 |
| | | KR 102270526 B1 | 29-06-2021 |
| CN 107190254 A | 22-09-2017 | NONE | |
| JP 2017048467 A | 09-03-2017 | CN 105556004 A | 04-05-2016 |
| | | JP 6283664 B2 | 21-02-2018 |
| | | JP 6297124 B2 | 20-03-2018 |
| | | JP 2017048467 A | 09-03-2017 |
| | | JP WO2015040998 A1 | 02-03-2017 |
| | | KR 20160060046 A | 27-05-2016 |
| | | TW 201524279 A | 16-06-2015 |
| | | WO 2015040998 A1 | 26-03-2015 |
| JP 2007131556 A | 31-05-2007 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20160368935 A1
- JP 2018016865 A
- JP 2014240522 A
- JP H06279461 A
- WO 2019243180 A
- WO 2020178146 A
- WO 2019058773 A
- JP 2016169300 A
- JP 6436819 B
- JP 2017002402 A
- JP 6370836 B
- JP 6392273 B
- US 20200399290 A


### Non-patent literature cited in the description


- Corrosion protection of copper with 3-glycidoxypropyltrimethoxysilane-based sol-gel coating through 3-amino-5-mercapto-1,2,4-triazole doping. *Journal of Research on Chemical Intermediates,* 2015, vol. 42 (2), 1315-1328
- *Chem. Eur.J.,* 2009, vol. 15, 6279-6288
- The role of oxide structure on copper wire to the rubber adhesion. *Applied Surface Science,* 2000, vol. 161, 355-364
- Reliability prediction in electronic packages using molecular simulation. *Electronic Components and Technology Conference,* 2005, 1314-1317